# EUROPEAN PATENT APPLICATION

(11) **EP 4 727 112 A1**
(43) Date of publication of application: **15.04.2026**
(21) Application number: 24872732.3
(22) Date of filing: 21.08.2024
(51) Int. Cl.: H04N 7/01, H04N 21/436, H04N 21/4363, G09G 5/00, H05K 1/02, G09G 3/20

(54) **ELECTRONIC DEVICE AND CONTROL METHOD THEREOF**

(30) Priority: 25.09.2023 KR 20230128564
(71) Applicant: Samsung Electronics Co., Ltd., Suwon-si, Gyeonggi-do 16677 (KR)
(72) Inventor: CHO, Yonghee, Suwon-si Gyeonggi-do 16677 (KR); KIM, Hwichul, Suwon-si Gyeonggi-do 16677 (KR); OH, Kihun, Suwon-si Gyeonggi-do 16677 (KR); JUNG, Gwanghyun, Suwon-si Gyeonggi-do 16677 (KR); CHUNG, Hyunwoo, Suwon-si Gyeonggi-do 16677 (KR)
(74) Representative: Appleyard Lees IP LLP
(86) International application number: PCT/KR2024/012453
(87) International publication number: WO 2025/071023

(57) **Abstract**

The electronic apparatus comprises: a substrate; an input/output interface including an input connector and an output connector disposed on the upper surface of the substrate; a conversion module disposed on the lower surface of the substrate; and at least one processor, in which the at least one processor acquires an input image through the input connector, converts the input image into a converted image on the basis of setting information related to image output, and displays the converted image through a display module.

## Description

### [TECHNICAL FIELD]

Apparatuses and methods consistent with the disclosure relate to an electronic apparatus and a control method thereof, and more particularly, to an electronic apparatus that processes input images received through a connector, and a control method thereof.

### [Background Art]

To display images received from an external device, a digital video signal may be received over a cable. To receive the digital video signal, there is a need to minimize a transmission loss in a high-speed signal interface including a connector.

A serial digital interface (SDI) is a method for transmitting uncompressed digital video signals over a cable. Images of various resolutions (e.g., SD, HD, FHD, UHD, etc.) may be transmitted through SDI.

Recently, as high-resolution image signals (e.g., 4K 60Hz 12Gbps and 4K 30Hz 6Gbps) are also being transmitted through SDI, the importance of circuit design to enhance high-speed signal transmission efficiency has increased. This is because a maximum distance required to transmit the high-resolution images increases depending on a circuit design.

Receiving devices (e.g., set-top boxes) utilizing SDI, which is capable of transmitting high-resolution image signals over cables, may normally display SD, HD, and FHD resolutions, or 6Gbps 4K 30Hz image signals, over 200M and 70M cables (based on TEST SPEC).

However, in 12Gbps 4K 60Hz images, images intermittently interrupts over 70M cables, thereby hindering normal image service.

Typical SDI connectors are disposed on an upper surface of a circuit board, and impedance discontinuities (stub sections) may occur due to connector pins. This leads to a sharp drop in signal quality in these impedance discontinuities.

### [Disclosure of Invention]

### [Solution to Problem]

The present disclosure is designed to address the above-described issues, and the present disclosure provides an electronic apparatus including a substrate having a connector for receiving input images and a module for processing input images disposed on opposite surfaces, and a control method thereof.

In accordance with an aspect of the disclosure, an electronic apparatus includes: a substrate; an input/output interface including an input connector and an output connector disposed on an upper surface of the substrate; a conversion module disposed on a lower surface of the substrate; and at least one processor, in which the at least one processor is configured to acquire an input image through the input connector, convert, by the conversion module, the input image into a converted image based on setting information related to image output, and display the converted image through a display module.

The electronic apparatus may further include: a transmission module connected to the conversion module, in which the at least one processor may be configured to transmit the converted image to the display module through the transmission module.

The electronic apparatus may further include: a timing module disposed on the lower surface of the substrate, in which the at least one processor may be configured to acquire compensation information for compensating for a time delay corresponding to the converted image through the timing module, and transmit the converted image and the compensation information to an external device through the output connector. The setting information may include at least one of size information of the display module that displays the converted image, resolution information of the display module, or color information of the display module.

A pin of the input connector and a pin of the output connector may be connected to the lower surface of the substrate through the substrate.

The substrate may include: a first capacitor disposed between the pin of the input connector corresponding to the lower surface of the substrate and the conversion module; and a second capacitor disposed between a pin of the output connector corresponding to the lower surface of the substrate and the timing module, and the at least one processor may be configured to filter noise through the first capacitor and the second capacitor.

The at least one processor may be configured to transmit the input image to the conversion module through a first impedance connecting the pin of the input connector and the first capacitor, and a second impedance connecting the first capacitor and the conversion module, and
transmit the converted image to the transmission module through a third impedance connecting the conversion module and the transmission module.

The at least one processor may be configured to transmit the converted image to the timing module through a fourth impedance connecting the transmission module and the timing module, and transmit the converted image and the compensation information to the output connector through a fifth impedance connecting the timing module and the second capacitor, and a sixth impedance connecting the second capacitor and the pin of the output connector.

A magnitude of the first impedance may be smaller than that of the second impedance, and a magnitude of the sixth impedance may be smaller than that of the fifth impedance.

The substrate may include: a first discharge element disposed between the pin of the input connector corresponding to the lower surface of the substrate and the first capacitor; and a second discharge element disposed between the pin of the output connector corresponding to the lower surface of the substrate and the second capacitor, and the at least one processor may be configured to filter static electricity through the first discharge element and the second discharge element.

In accordance with another aspect of the disclosure, a control method of an electronic apparatus including an input/output interface including an input connector and an output connector disposed on an upper surface of a substrate, and a conversion module disposed on a lower surface of the substrate includes: acquiring an input image through the input connector; converting, by the conversion module, the input image into a converted image based on setting information related to image output; and displaying the converted image through a display module.

The electronic apparatus may further include a transmission module connected to the conversion module, and the control method may further include transmitting the converted image to the display module through the transmission module.

The electronic apparatus may further include a timing module disposed on the lower surface of the substrate, and the control method may include: acquiring compensation information for compensating for a time delay corresponding to the converted image through the timing module; and transmitting the converted image and the compensation information to an external device through the output connector. The setting information may include at least one of size information of the display module that displays the converted image, resolution information of the display module, or color information of the display module.

A pin of the input connector and a pin of the output connector may be connected to the lower surface of the substrate through the substrate.

The substrate may include a first capacitor disposed between the pin of the input connector corresponding to the lower surface of the substrate and the conversion module, and a second capacitor disposed between the pin of the output connector corresponding to the lower surface of the substrate and the timing module, and

the control method may further include filtering noise through the first capacitor and the second capacitor.

The control method may further include transmitting the input image to the conversion module through the first impedance connecting the pin of the input connector and the first capacitor and the second impedance connecting the first capacitor and the conversion module, and transmitting the converted image to the transmission module through the third impedance connecting the conversion module and the transmission module.

The control method may further include transmitting the converted image to the timing module through the fourth impedance connecting the transmission module and the timing module, and transmitting the converted image and the compensation information to the output connector through the fifth impedance connecting the timing module and the second capacitor, and the sixth impedance connecting the second capacitor and the pin of the output connector.

The magnitude of the first impedance may be smaller than that of the second impedance, and the magnitude of the sixth impedance may be smaller than that of the fifth impedance.

The substrate may include: the first discharge element disposed between the pin of the input connector corresponding to the lower surface of the substrate and the first capacitor; and a second discharge element disposed between the pin of the output connector corresponding to the lower surface of the substrate and the second capacitor, and the control method may further include filtering static electricity through the first discharge element and the second discharge element.

### [Brief Description of Drawings]

FIG. 1 is a diagram for describing an operation of providing an image through an electronic apparatus according to an embodiment.
FIG. 2 is a diagram for describing an operation of providing an image through the electronic apparatus according to an embodiment.
FIG. 3 is a block diagram for describing the electronic apparatus according to an embodiment.
FIG. 4 is a block diagram for describing the electronic apparatus according to an embodiment.
FIG. 5 is a diagram for describing a process of processing an image in an electronic apparatus according to an embodiment.
FIG. 6 is a diagram for describing the process of processing an image in an electronic apparatus according to an embodiment.
FIG. 7 is a diagram for describing a substrate having some modules for image processing disposed at a bottom according to an embodiment.
FIG. 8 is a diagram for describing a substrate having some modules for image processing disposed at the bottom according to an embodiment.
FIG. 9 is a diagram for describing some impedance connected to a connector according to an embodiment.
FIG. 10 is a diagram illustrating some impedance connected to a connector, according to an embodiment.
FIG. 11 is a diagram for describing impedance on a substrate where some modules for image processing are disposed at a top according to an embodiment.
FIG. 12 is a diagram for describing impedance on a substrate where some modules for image processing are disposed at a top according to an embodiment.
FIG. 13 is a diagram for describing loss values according to frequency depending on module arrangement according to various embodiments.
FIG. 14 is a diagram for describing capacitor arrangement according to various embodiments.
FIG. 15 is a diagram for describing a change in impedance depending on module arrangement according to various embodiments.
FIG. 16 is a diagram for describing loss values according to frequency depending on module arrangement according to various embodiments.
FIG. 17 is a diagram for describing an eye diagram according to a module arrangement according to various embodiments.
FIG. 18 is a diagram for describing test results according to a type of images and a length of cables according to various embodiments.
FIG. 19 is a drawing for describing a layout structure of a substrate according to an embodiment.
FIG. 20 is a flowchart for describing a control method of an electronic apparatus according to an embodiment.

### [Mode for Invention]

Hereinafter, the present disclosure will be described in detail with reference to the accompanying drawings.

General terms that are currently widely used were selected as terms used in embodiments of the present disclosure in consideration of functions in the present disclosure, but may be changed depending on the intention of those skilled in the art or a judicial precedent, the emergence of a new technique, and the like. In addition, in a specific case, terms arbitrarily chosen by an applicant may exist. In this case, the meaning of such terms will be mentioned in detail in a corresponding description portion of the present disclosure. Therefore, the terms used in the present disclosure should be defined on the basis of the meaning of the terms and the contents throughout the present disclosure rather than simple names of the terms.

In the disclosure, an expression "have," "may have," "include," "may include," or the like, indicates existence of a corresponding feature (for example, a numerical value, a function, an operation, a component such as a part, or the like), and does not exclude existence of an additional feature.

An expression "at least one of A and/or B" is to be understood to represent "A" or "B" or "any one of A and B."

Expressions "first," "second," "1st" or "2nd" or the like, used in the present specification may indicate various components regardless of a sequence and/or importance of the components, will be used only in order to distinguish one component from the other components, and do not limit the corresponding components.

When it is mentioned that any component (for example: a first component) is (operatively or communicatively) coupled with/to or is connected to another component (for example: a second component), it is to be understood that any component is directly coupled to another component or may be coupled to another component through the other component (for example: a third component).

Singular expressions are intended to include plural expressions unless the context clearly represents otherwise. It will be further understood that the terms "comprises" or "have" used in this specification, specify the presence of stated features, steps, operations, components, parts mentioned in this specification, or a combination thereof, but do not preclude the presence or addition of one or more other features, numerals, steps, operations, components, parts, or a combination thereof.

In the disclosure, a "module" or a "~er/or" may perform at least one function or operation, and be implemented by hardware or software or be implemented by a combination of hardware and software. In addition, a plurality of "modules" or a plurality of "~ers/~ors" may be integrated in at least one module and be implemented by at least one processor (not illustrated) except for a "module" or a "~er/or" that needs to be implemented by specific hardware.

In the present disclosure, the term user may refer to a person using an electronic apparatus or a device (e.g., an artificial intelligence electronic apparatus) using an electronic apparatus.

Hereinafter, an embodiment of the disclosure will be described in detail with reference to the accompanying drawings.

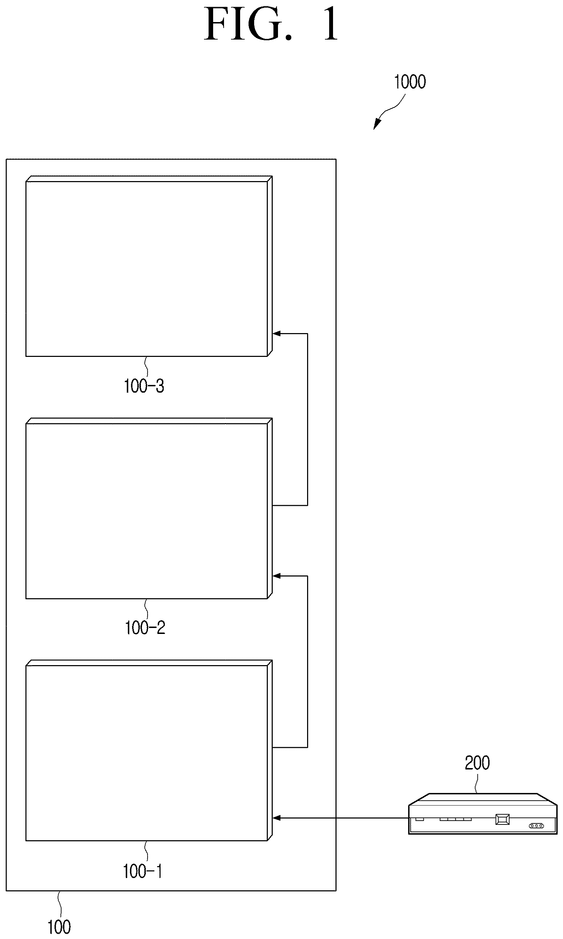

FIG. 1 is a diagram for describing an operation of providing an image through an electronic apparatus 100, according to an embodiment.

A system 1000 may include an electronic apparatus 100 and an image providing device 200. The electronic apparatus 100 may be a device that provides (or displays) an image to a user.

The electronic apparatus 100 may include a display or a display device. The electronic apparatus 100 may receive an image through the image providing device 200 and output the received image through the display or display device. The electronic apparatus 100 may be a device that provides content (e.g., broadcast images). The electronic apparatus 100 may be described as a signage device or a digital signage device.

The image providing device 200 may be a set-top box. The image providing device 200 may receive an image through an external server. The image providing device 200 may provide an image received by an electronic apparatus 100.

The image providing device 200 may refer to the external server. The image providing device 200 may provide an image to the electronic apparatus 100.

The electronic apparatus 100 may include at least one display device 100-1, 100-2, and 100-3. At least one display device 100-1, 100-2, and 100-3 may provide an image received from the image providing device 200.

The electronic apparatus 100 may transmit an image to the first display device 100-1.

The first display device 100-1 may receive an image from the electronic apparatus 100. The first display device 100-1 may output the received image. The first display device 100-1 may transmit the received image back to the second display device 100-2.

The second display device 100-2 may receive an image from the first display device 100-1. The second display device 100-2 may output the received image. The second display device 100-2 may transmit the received image back to the third display device 100-3.

The third display device 100-3 may output the received image.

The image may be described as video information, image information, image data, a frame, frame information, etc.

For example, at least one display device 100-1, 100-2, and 100-3 may provide the same image received from the image providing device 200. At least one display device 100-1, 100-2, and 100-3 each may output the same image.

For example, at least one display device 100-1, 100-2, and 100-3 may divide and provide an image received from the image providing device 200. The first display device 100-1 may output a first portion of the image, a second display device 100-2 may output a second portion of the image, and the third display device 100-3 may output a third portion of the image. The electronic apparatus 100 may divide the received image based on the arrangement structure of each display device 100-1, 100-2, and 100-3. The electronic apparatus 100 may control the transmission of divided video information to each display device 100-1, 100-2, and 100-3.

In FIG. 1, the electronic apparatus 100 is described as including at least one display device 100-1, 100-2, and 100-3. According to various embodiments, the electronic apparatus 100 may refer to at least one display device 100-1, 100-2, and 100-3.

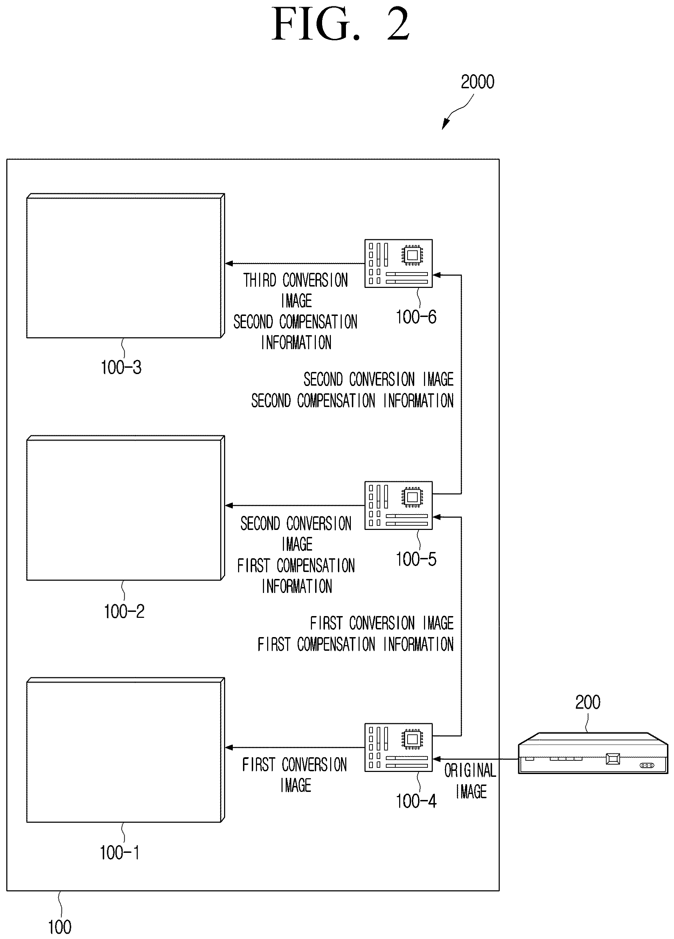

FIG. 2 is a diagram illustrating an operation of providing an image through the electronic apparatus 100, according to an embodiment.

A system 2000 may include the electronic apparatus 100 and the image providing device 200. Some operations for the electronic apparatus 100 and the image providing device 200 are described in FIG. 1.

The electronic apparatus 100 may include at least one image processing device 100-4, 100-5, and 100-6 used prior to transmitting an image to at least one display device 100-1, 100-2, and 100-3.

At least one image processing device 100-4, 100-5, and 100-6 may perform processing operations related to an image received through the image providing device 200. The processing operations related to the image may include operations for converting feature information of the image or operations for compensating for a time delay of the image. The feature information may include one of image size, image brightness, and image color. The Time delay may refer to a problem in which synchronization is lost as data signals are transmitted when data is output from a plurality of devices. The time delay compensation may include an operation for compensating for the time delay so that data is output in sync from the plurality of devices.

The image providing device 200 may receive an input image from the electronic apparatus 100. The received input image may be described as an original image, a source image, image content, source information, etc. The electronic apparatus 100 may transmit the input image to the first image processing device 100-4.

The first image processing device 100-4 may receive the input image. The first image processing device 100-4 may convert the received input image into a first converted image based on first setting information of the first display device 100-1. The first setting information may include at least one of size information of the first display device 100-1, resolution information that may be provided by the first display device 100-1, and color information that may be provided by the first display device 100-1. The first image processing device 100-4 may transmit the first converted image to the first display device 100-1. The first display device 100-1 may receive the first converted image from the first image processing device 100-4. The first display device 100-1 may output the first converted image. The first image processing device 100-4 may generate (or acquire) first compensation information for compensating for a time delay for the first converted image. The first image processing device 100-4 may transmit the first converted image and the first compensation information to the second image processing device 100-5.

The second image processing device 100-5 may receive the first converted image and the first compensation information. The second image processing device 100-5 may convert the received first converted image into a second converted image based on second setting information of the second display device 100-2. The second setting information may include at least one of size information of the second display device 100-2, resolution information that may be provided by the second display device 100-2, and color information that may be provided by the second display device 100-2. The second setting information may include at least one of size information of the second display device 100-2, resolution information that may be provided by the second display device 100-2, and color information that may be provided by the second display device 100-2. The second image processing device 100-5 may transmit the second converted image and the first compensation information to the second display device 100-2. The second display device 100-2 may receive the second converted image and the first compensation information from the second image processing device 100-5. The second display device 100-2 may output the second converted image based on the first compensation information. The second image processing device 100-5 may generate (or acquire) second compensation information for compensating for a time delay for the second converted image. The second image processing device 100-5 may transmit the second converted image and the second compensation information to the third image processing device 100-6.

The third image processing device 100-6 may receive the second converted image and the second compensation information. The third image processing device 100-6 may convert the received second converted image into a third converted image based on third setting information of the third display device 100-3. The third setting information may include at least one of size information of the third display device 100-3, resolution information that may be provided by the third display device 100-3, and color information that may be provided by the third display device 100-3. The third image processing device 100-6 may transmit the third converted image and the second compensation information to the third display device 100-3. The third display device 100-3 may receive the third converted image and the second compensation information from the third image processing device 100-6. The third display device 100-3 may output the third converted image based on the second compensation information.

The display device 100-1 may be described as a display module. The image processing device 100-4 may be described as an image processing module.

According to an embodiment, the first display device 100-1 and the first image processing device 100-4 may be included in the first device. The second display device 100-2 and the second image processing device 100-5 may be included in the second device. The third display device 100-3 and the third image processing device 100-6 may be included in the third device.

According to an embodiment, the first display device 100-1 may include the first image processing device 100-4. The second display device 100-2 may include the second image processing device 100-5. The third display device 100-3 may include the third image processing device 100-6.

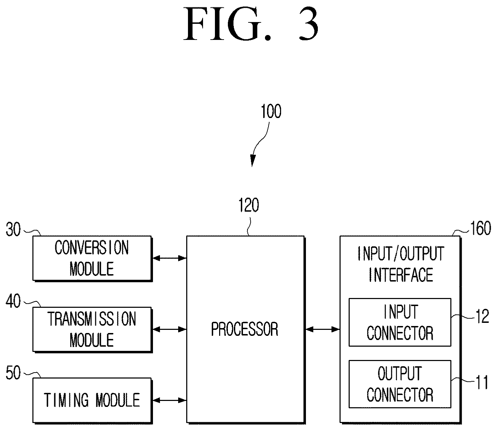

FIG. 3 is a block diagram for describing the electronic apparatus 100 according to an embodiment.

The electronic apparatus 100 may include at least one of a conversion module 30, a transmission module 40, a timing module 50, and an input/output interface 160. The input/output interface 160 may include at least one of an input connector 11 and an output connector 12.

The conversion module 30, the transmission module 40, the timing module 50, and the input/output interface 160 may be disposed on a substrate 10 included in the electronic apparatus 100. The substrate 10 may be composed of at least one layer and may include an upper surface and a lower surface. The upper surface may refer to a top layer, and the lower surface may refer to a bottom layer. The substrate 10 may include at least one of a conductor region and an insulator region. The substrate 10 may be described as a circuit board or a printed circuit board.

According to an embodiment, the upper surface may be described as a first surface, and the lower surface may be described as a second surface. The input connector 11 and the output connector 12 may be disposed on the first surface of the substrate 10, and the conversion module 30 and/or the timing module 50 may be disposed on the second surface (different from the first surface) of the substrate 10.

According to an embodiment, the conversion module 30, the transmission module 40, and the timing module 50 may be included in at least one processor 120. At least one processor 120 may be implemented to include at least one integrated circuit. The at least one processor 120 may be described as a processor group, a processor module, a processor unit, etc.

At least one processor 120 may control various operations performed in the electronic apparatus 100. For example, at least one processor 120 may receive an input image from an external device (or an external source or device) through the input/output interface 160. At least one processor 120 may process an input image in a preset manner or generate (or acquire) compensation information for time delay through the conversion module 30, the transmission module 40, the timing module 50, etc.

The electronic apparatus 100 may include the substrate 10, the input/output interface 160 including the input connector 11 and the output connector 12 disposed on the upper surface of the substrate 10, the conversion module 30 disposed on the lower surface of the substrate 10, the transmission module 40 connected to the substrate 10, the timing module 50 disposed on the lower surface of the substrate 10, and at least one processor 120 connected to the conversion module 30, the transmission module 40, or the timing module 50.

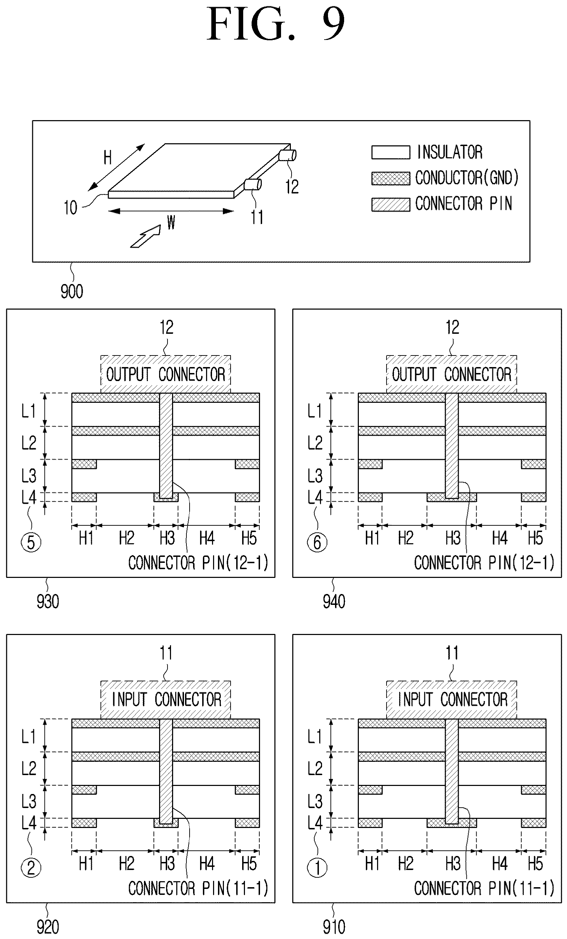

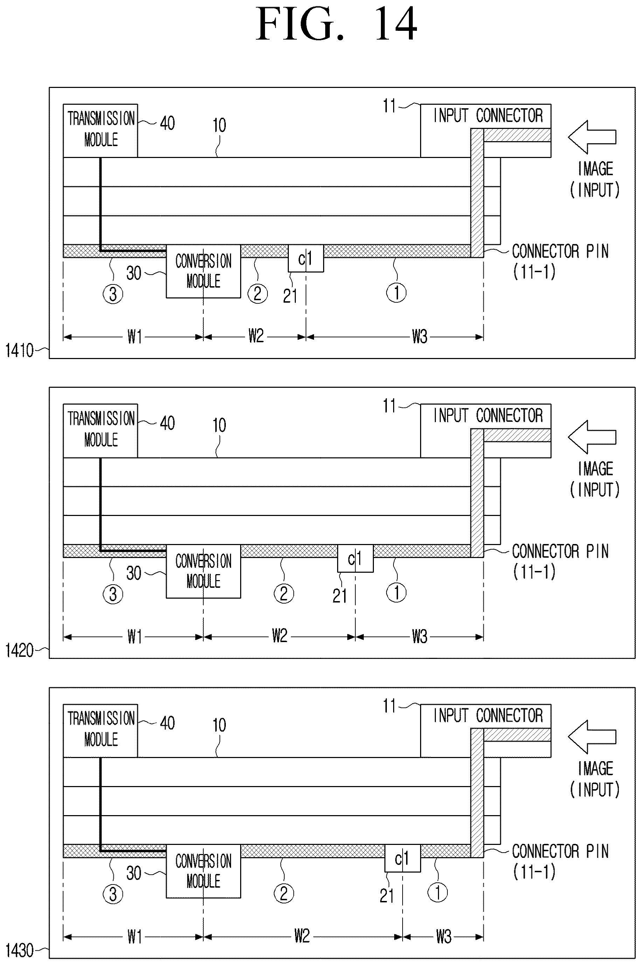

The substrate 10 may be a circuit board for arranging at least one hardware component included in the electronic apparatus 100. The substrate 10 may include at least one of a conductor and an insulator. The specific structure related to the substrate 10 is described in FIGS. 9 and 14.

At least one processor 120 may acquire the input image through the input connector 11, convert, by the conversion module 30, the input image into the converted image based on the setting information related to image output, transmit the converted image to the display module through the transmission module 40, acquire the compensation information for compensating for the time delay corresponding to the converted image through the timing module 50, and transmit the converted image and compensation information to the external device through the output connector 12.

At least one processor 120 may receive the input image through the input connector 11. At least one processor 120 may acquire the input image from the external source. The external source may be a content providing device that provides content. For example, the external source may be a device that stores content and provides the content directly. For example, the external source may be a device that receives content through the external server and provides the received content. The input image may be described as an original image, a source image, image content, source information, etc.

The input image may include at least one of an image signal and an audio signal. For example, the input image may include both an image signal and an audio signal. The input image may be described as input content, an input source, input information, an input signal, etc.

The conversion module 30 may be an equalization (EQ) module. The conversion module 30 may include an equalizer module. The conversion module 30 may convert the feature information of the image. The conversion module 30 may convert an image based on the setting information of the display device to which the image is output. The image output by the conversion module 30 may be described as the converted image (or the first converted image).

The converted image may include at least one of the converted image signal and the converted audio signal. For example, the converted image may include both the converted image signal and converted audio signal. The converted image may be described as converted content, modified content, conversion information, etc.

The conversion module 30 may be described as a signal conversion module, a content conversion module, a restoration module, etc.

The conversion module 30 may extract the feature information from the input signal and modify the extracted feature information based on the setting information related to the display device (or display module).

The image received by the conversion module 30 may include both the image signal and audio signal. The conversion module 30 may perform a conversion operation on at least one of the image signal and the audio signal included in the received image.

The conversion module 30 may perform a function of restoring the received input image. The function of restoration may include an operation of modifying the original image to be suitable for the display device (or display module) based on the input image.

The setting information may include at least one of the size information of the display module on which the converted image will be displayed, the resolution information of the display module, or the color information of the display module.

The setting information may include specification information of the display module on which the converted image will be displayed. The specification information may include at least one of the size information, the resolution information, the color information, ratio information, refresh rate information, and brightness information supported by the display module.

The operation of converting the input image into the converted image may be intended to provide a suitable screen (or a screen intended by the user) to the viewer through the display module.

The transmission module 40 may include a bridge integrated circuit (BIC). The transmission module 40 may perform an operation of transmitting the converted image to the display module (display or display device).

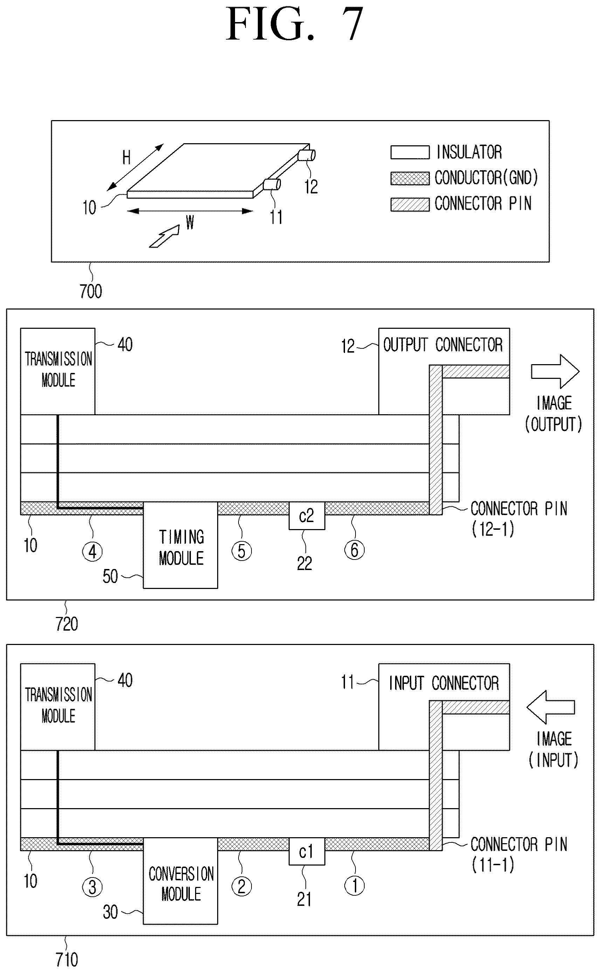

According to an embodiment, the transmission module 40 may be disposed on the upper surface of the substrate 10. A description related thereto is described with reference to FIG. 7.

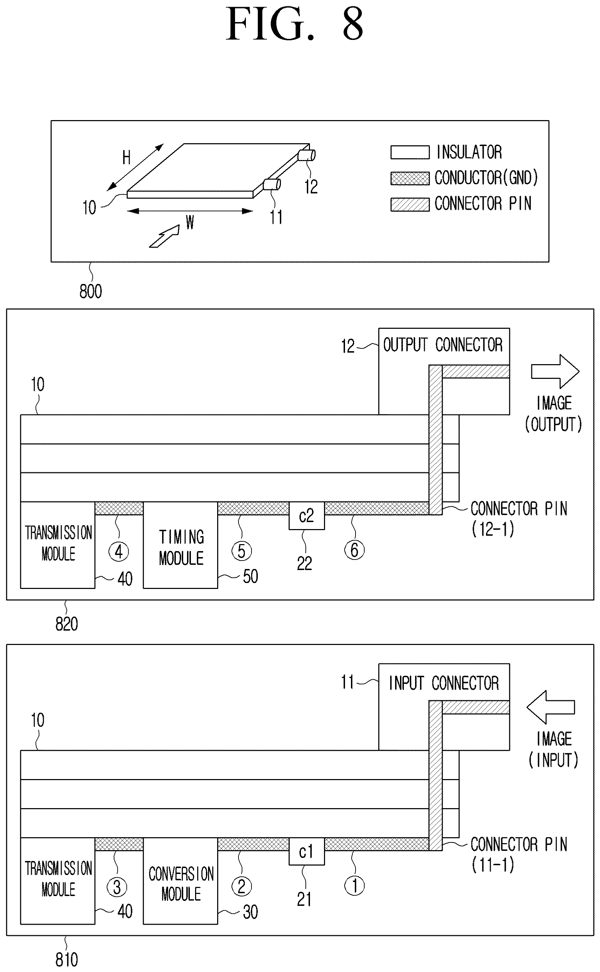

According to an embodiment, the transmission module 40 may be disposed on the lower surface of the substrate 10. A description related thereto is described with reference to FIG. 8.

The timing module 50 may be a module that performs a compensation operation for time delay. The electronic apparatus 100 may include a plurality of displays or a plurality of display devices. A compensation operation for time delay may be performed to synchronize images output from the plurality of displays (or display devices). The timing module 50 may acquire compensation information (or first compensation information). The compensation information may be described as time compensation information, delay information for time compensation, timing information, sync information, etc.

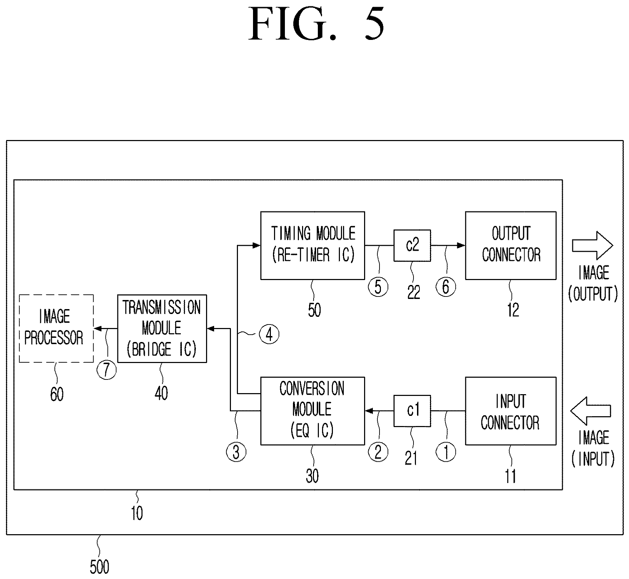

A description related to the conversion module 30, the transmission module 40, the timing module 50, etc., is described with reference to FIG. 5.

At least one processor 120 may transmit the converted image to the display module through the transmission module 40 and control the display module to display the converted image.

According to an embodiment, the display module may be included in the electronic apparatus 100. At least one processor 120 may transmit the converted image to the display module through the transmission module 40. At least one processor 120 may transmit the converted image to the image processor included in the electronic apparatus 100. The image processor may perform some processing operations necessary to display the converted image on the display module. The image processor may process the converted image and transmit the processed image to the display module. For convenience of description, the image before the processing operation of the image processor may be described as the converted image (the first converted image), and the image after the processing operation of the image processor may be described as the processed image (the second converted image).

According to an embodiment, the display module may be included in an external display device. At least one processor 120 may transmit the converted image to the external display device through the transmission module 40.

For example, the electronic apparatus 100 and the external display device may be connected through a separate connector. The electronic apparatus 100 and the external display device may transmit the converted image to the external display device through a separate connector other than the input connector 12 and the output connector 11.

For example, the electronic apparatus 100 and the external display device may be connected through a wired or wireless communication interface. A communication session between the electronic apparatus 100 and the external display device may be established through the wired communication interface (e.g., a communication line) or the wireless communication interface (e.g., a short-range communication method). At least one processor 120 may transmit the converted image to the external display device through the wired or wireless communication interface. The external display device may receive the converted image and display the converted image through the display module.

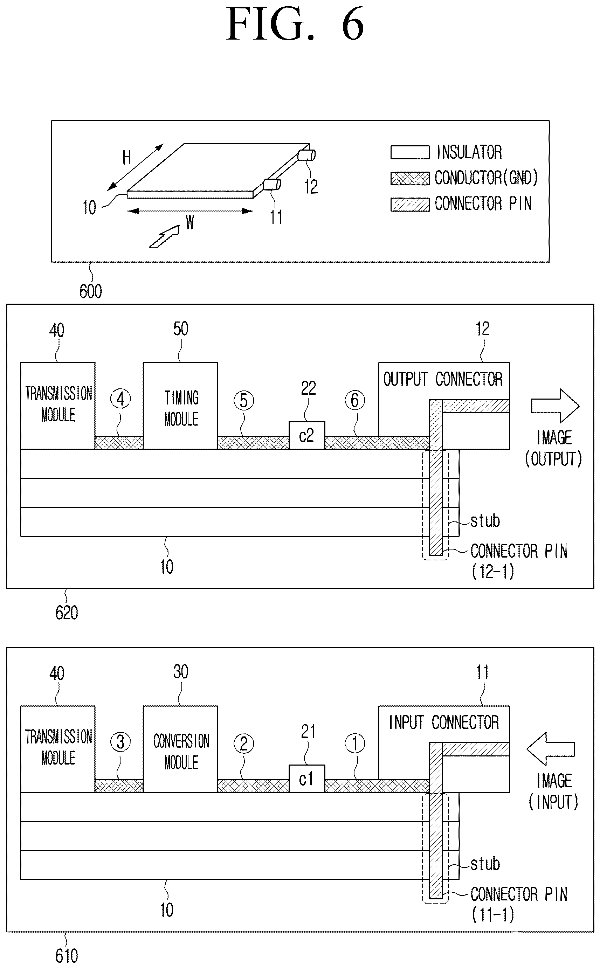

A pin 11-1 of the input connector 11 and a pin of the output connector may be connected to the lower surface of the substrate 10 through the substrate 10. A description related thereto is described with reference to FIGS. 6, 7, and 8.

The electronic apparatus 100 may include a first capacitor 21 disposed between the pin 11-1 of the input connector 11 corresponding to the lower surface of the substrate 10 and the conversion module 30.

The electronic apparatus 100 may include a second capacitor 22 disposed between a pin 12-1 of the output connector 12 corresponding to the lower surface of the substrate 10 and the timing module 50.

At least one processor 120 may filter noise through the first capacitor 21 and the second capacitor 22.

The first capacitor 21 and the second capacitor 22 may remove noise or stabilize impedance. The first capacitor 21 and the second capacitor 22 may be described as a noise filter, a decoupling capacitor, or the like.

At least one processor 120 may transmit the input image to the conversion module 30 through a first impedance connecting the pin 11-1 of the input connector 11 and the first capacitor 21 and a second impedance connecting the first capacitor 21 and the conversion module 30, and may transmit the converted image to the transmission module 40 through a third impedance connecting the conversion module 30 and the transmission module 40. A description related thereto is described with reference to an embodiment 710 of FIG. 7 and an embodiment 810 of FIG. 8.

At least one processor 120 may transmit the converted image to the timing module 50 through a fourth impedance connecting the transmission module 40 and the timing module 50, and transmit the converted image and compensation information to the output connector 12 through a fifth impedance connecting the timing module 50 and the second capacitor 22 and a sixth impedance connecting the second capacitor 22 and the pin 12-1 of the output connector 12. A description related thereto is described with reference to an embodiment 720 of FIG. 7 and an embodiment 820 of FIG. 8.

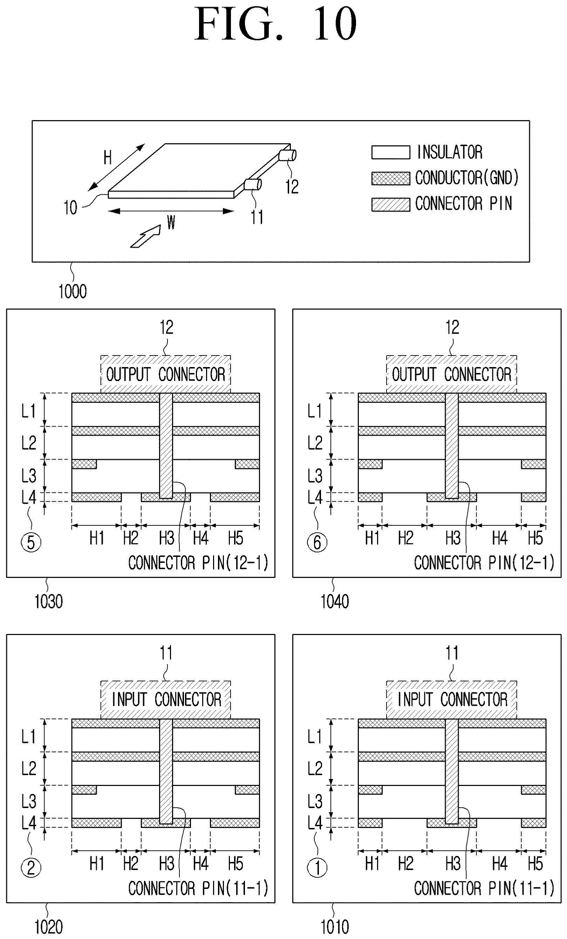

A magnitude of the first impedance may be smaller than that of the second impedance, and a magnitude of the sixth impedance may be smaller than that of the fifth impedance. A description related thereto is described with reference to FIGS. 9 and 10.

The electronic apparatus 100 may include a first discharge element disposed between the pin 11-1 of the input connector 11 corresponding to the lower surface of the substrate 10 and the first capacitor 21, and a second discharge element disposed between the pin 12-1 of the output connector 12 corresponding to the lower surface of the substrate 10 and the second capacitor 22.

The discharge element may be described as an electrostatic discharge (ESD) diode, a discharge diode, or the like.

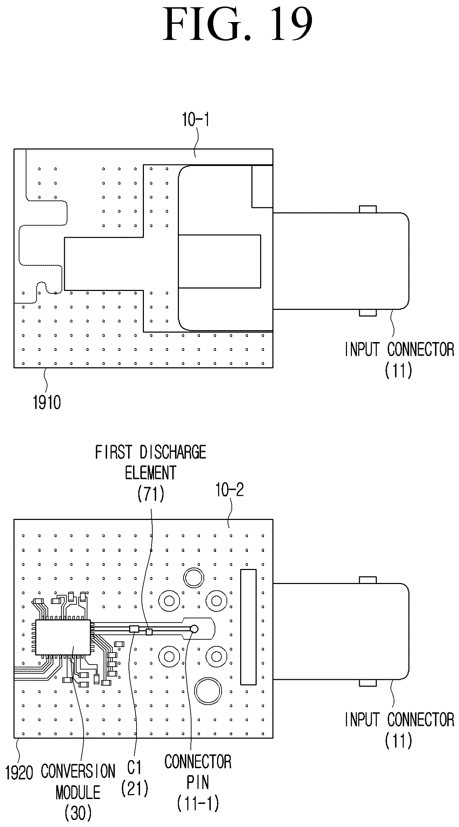

At least one processor 120 may filter static electricity through the first discharge element and the second discharge element. A description related thereto is described with reference to FIG. 19.

The input/output interface 160 may be a serial digital interface (SDI).

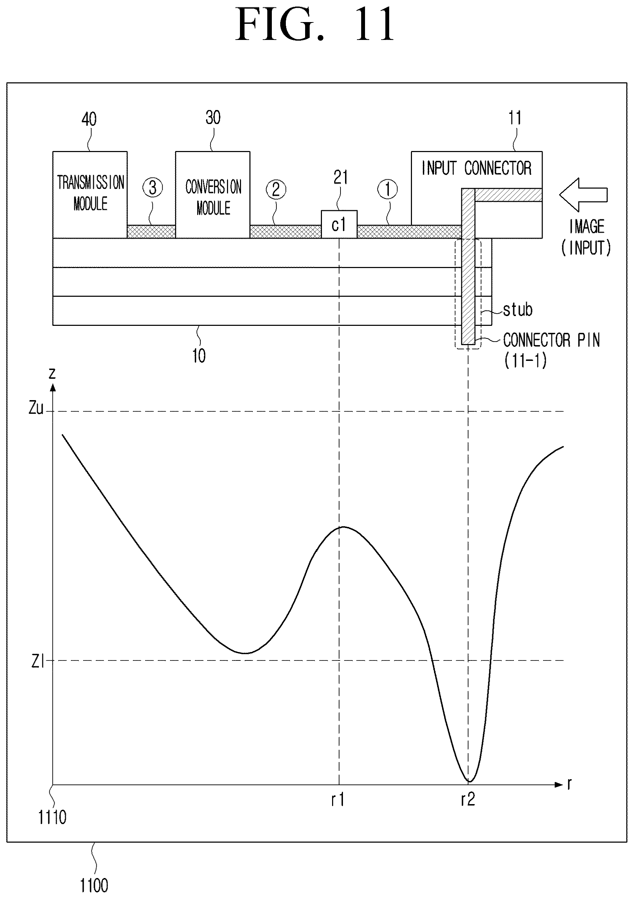

An interface structure of the electronic apparatus 100 may resolve impedance imbalance. The electronic apparatus 100 may reduce transmission loss and increase data transmission efficiency. A descriptions related thereto is described with reference to FIGS. 11, 12, 13, 14, 15, 16, 17, 18, etc.

The electronic apparatus 100 may improve the quality of an image provision service by minimizing signal transmission loss in a high-speed signal I/F (BW Freq. 10 Gbps or higher) using a dip type connector. A device (e.g., a driver) for transmitting an image signal and a device (e.g., a receiver) for receiving an image signal may transmit (or receive) an image signal through an improved circuit board.

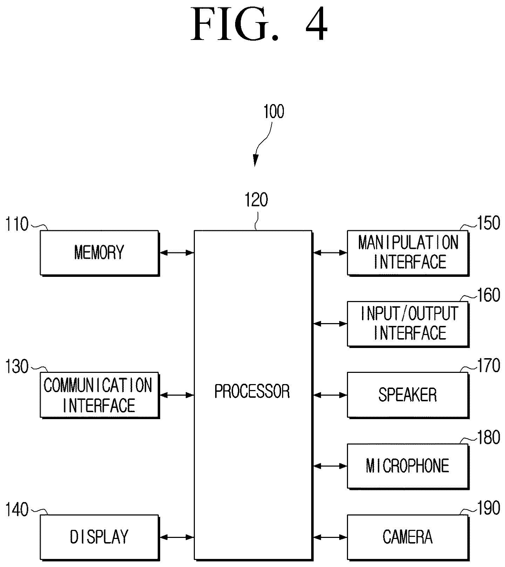

FIG. 4 is a block diagram for describing the electronic apparatus 100 according to an embodiment.

Referring to FIG. 4, the electronic apparatus 100 may include at least one of a memory 110, at least one processor 120, a communication interface 130, a display 140, a manipulation interface 150, an input/output interface 160, a speaker 145, a microphone 160, and a camera 190. The display 140 may be described as a display module or a display device.

The memory 110 may be implemented by an internal memory such as a read-only memory (ROM) (for example, an electrically erasable programmable read-only memory (EEPROM)), a random access memory (RAM), or the like, included in at least one processor 120 or be implemented by a memory separate from at least one processor 120. In this case, the memory 110 may be implemented in a form of a memory embedded in the electronic apparatus 100 or a form of a memory attachable to and detachable from the electronic apparatus 100, depending on a data storing purpose. For example, data for driving the electronic apparatus 100 may be stored in the memory embedded in the electronic apparatus 100, and data for an extension function of the electronic apparatus 100 may be stored in the memory attachable to and detachable from the electronic apparatus 100.

The memory embedded in the electronic apparatus 100 may be implemented by at least one of a volatile memory (for example, a dynamic RAM (DRAM), a static RAM (SRAM), a synchronous dynamic RAM (SDRAM), or the like) or a nonvolatile memory (for example, a one time programmable ROM (OTPROM), a programmable ROM (PROM), an erasable and programmable ROM (EPROM), an electrically erasable and programmable ROM (EEPROM), a mask ROM, a flash ROM, a flash memory (for example, a NAND flash, a NOR flash, or the like), a hard drive, or a solid state drive (SSD)), and the memory attachable to and detachable from the electronic apparatus 100 may be implemented in a form such as a memory card (for example, a compact flash (CF), a secure digital (SD), a micro-SD, a mini-SD, an extreme digital (xD), a multi-media card (MMC), or the like), an external memory (for example, a universal serial bus (USB) memory) connectable to a USB port, or the like.

The memory 110 may store at least one instruction. At least one processor 120 may perform various operations based on an instruction stored in the memory 110.

At least one processor 120 may be implemented by a digital signal processor (DSP), a microprocessor, or a time controller (TCON) that processes a digital signal. However, the processor 120 is not limited thereto, but may include one or more of a central processing unit (CPU), a micro controller unit (MCU), a micro processing unit (MPU), a controller, an application processor (AP), a graphics-processing unit (GPU), a communication processor (CP), and an advanced reduced instruction set computer (RISC) machines (ARM) processor, or may be defined by these terms. At least one processor 120 may be implemented by a system-on-chip (SoC) or a large scale integration (LSI) in which a processing algorithm is embedded, or may be implemented in a field programmable gate array (FPGA) form. At least one processor 120 may perform various functions by executing computer executable instructions stored in the memory.

The communication interface 130 is a component performing communication with various types of external apparatuses depending on various types of communication manners. The communication interface 130 may include a wireless communication module or a wired communication module. Each communication module may be implemented in the form of at least one hardware chip.

The wireless communication module may be a module that wirelessly communicates with an external device. For example, the wireless communication module may include at least one of a Wi-Fi module, a Bluetooth module, an infrared communication module, or other communication modules.

The Wi-Fi module and the Bluetooth module may perform communication in the Wi-Fi method and the Bluetooth method, respectively. In the case of using the Wi-Fi module or the Bluetooth module, various pieces of connection information such as a service set identifier (SSID), a session key, and the like, is first transmitted and received, communication is connected using the various pieces of connection information, and various information may then be transmitted and received.

The infrared communication module performs communication according to an infrared data association (IrDA) technology of wirelessly transmitting data to a short distance using an infrared ray disposed between a visible ray and a millimeter wave.

Other wireless communication modules may include at least one communication chip performing communication according to various wireless communication standards such as zigbee, 3^{rd} generation (3G), 3^{rd} generation partnership project (3GPP), long term evolution (LTE), LTE advanced (LTE-A), 4^{th} generation (4G), 5^{th} generation (5G), and the like, in addition to the communication manner described above.

The wired communication module may be a module that communicates with an external device in a wired manner. For example, the wired communication module may include at least one of a local area network (LAN) module, an Ethernet module, a pair cable, a coaxial cable, an optical fiber cable, or an ultra wide-band (UWB) module.

According to various embodiments, the communication interface 130 may use the same communication module (for example, the WiFi module) to communicate with an external device such as a remote control and the external server.

According to various embodiments, the communication interface 130 may use different communication modules to communicate with an external device such as a remote control and the external server. For example, the communication interface 130 may use at least one of the Ethernet module or the WiFi module to communicate with the external server, and may use a Bluetooth module to communicate with the external device such as the remote control. However, this is only an embodiment, and the communication interface 130 may use at least one of various communication modules in a case in which it communicates with a plurality of external devices or external servers.

The display 140 may be implemented by various types of displays such as a liquid crystal display (LCD), an organic light emitting diode (OLED) display, a plasma display panel (PDP), and the like. A driving circuit, a backlight unit, and the like, that may be implemented in a form such as an amorphous silicon thin film transistor (a-si TFT), a low temperature poly silicon (LTPS) TFT, an organic TFT (OTFT), and the like, may be included in the display 140. The display 140 may be implemented as a touch screen coupled with a touch sensor, a flexible display, a three-dimensional display (3D display), etc. According to an embodiment of the present disclosure, the display 140 may include not only a display panel that outputs an image, but also a bezel that houses the display panel. In particular, according to an embodiment of the present disclosure, the bezel may include a touch sensor (not illustrated) for detecting user interaction.

The manipulation interface 150 may be implemented as a device such as a button, a touch pad, a mouse, and a keyboard, or may be implemented as a touch screen capable of performing the above-described display function and manipulation input function together. The button may be various types of buttons such as a mechanical button, a touch pad, a wheel, and the like, formed in any region such as a front surface portion, a side surface portion, a rear surface portion, and the like, of a body appearance of the electronic apparatus 100.

The input/output interface 160 may be an interface of any one of a high definition multimedia interface (HDMI), a mobile high-definition link (MHL), a universal serial bus (USB), a display port (DP), Thunderbolt, a video graphics array (VGA) port, an RGB port, a D-subminiature (D-SUB), and a digital visual interface (DVI). The input/output interface 160 may input/output at least one of audio and video signals. According to the implementation example, the input/output interface 160 may include a port for inputting/outputting only an audio signal and a port for inputting/outputting only a video signal as separate ports, or may be implemented as a single port for inputting/outputting both an audio signal and a video signal. The electronic apparatus 100 may transmit at least one of audio and video signals to an external device (e.g., an external display device or an external speaker) through the input/output interface 160. An output port included in the input/output interface 160 may be connected to an external device, and the electronic apparatus 100 may transmit at least one of the audio and video signals to the external device through the output port.

The input/output interface 160 may be connected to a communication interface. The input/output interface 160 may transmit information received from an external device to the communication interface, or transmit information received through the communication interface to an external device.

The speaker 170 may be a component that outputs not only various audio data but also various notification sounds, voice messages, etc.

The microphone 180 is a component for receiving a user voice or other sounds and converting the user voice or other sounds into audio data. The microphone 180 may receive the user voice in an activated state. For example, the microphone 180 may be formed integrally on an upper side or in a front direction, a side direction, etc., of the electronic apparatus 100. The microphone 180 may include various configurations such as a microphone that collects user voices in analog form, an amplifier circuit that amplifies the collected user voices, an A/D conversion circuit that samples the amplified user voices and converts the amplified user voices into digital signals, and a filter circuit that removes noise components from the converted digital signals.

The camera 190 captures a subject and generates a captured image. Here, the captured image includes both moving and still images. The camera 190 may acquire an image of at least one external device, and may be implemented as a camera, a lens, an infrared sensor, or the like.

The camera 190 may include a lens and an image sensor. A type of lens includes a general general-purpose lens, a wide-angle lens, a zoom lens, and the like, and may be determined according to the type, characteristic, use environment, and the like of the electronic apparatus 100. As the image sensor, a complementary metal oxide semiconductor (CMOS), a charge coupled device (CCD), and the like may be used.

According to various embodiments, the electronic apparatus 100 may include the display 140. The electronic apparatus 100 may directly display the captured image or content on the display 140.

According to various embodiments, the electronic apparatus 100 may not include the display 140. The electronic apparatus 100 may be connected to an external display device and may transmit images or content stored in the electronic apparatus 100 to the external display device.

The electronic apparatus 100 may transmit the images or content to the external display device along with a control signal for controlling the display of the images or content on the external display device. The external display device may be connected to the electronic apparatus 100 via the communication interface 130 or the input/output interface 160. For example, the electronic apparatus 100 may not include a display like a set top box (STB).

Also, the electronic apparatus 100 may include only a small display capable of displaying only simple information such as text information. The electronic apparatus 100 may transmit the images or content to the external display device through the communication interface 130 through the wire or wireless connection, or via an input/output interface 160.

There may be various embodiments in which the electronic apparatus 100 performs an operation corresponding to the user voice signal received through the microphone 180.

According to various embodiments, the electronic apparatus 100 may control the display 140 based on the user voice signal received through the microphone 180. For example, when the user voice signal for displaying content A is received, the electronic apparatus 100 may control the display 140 to display content A.

According to various embodiments, the electronic apparatus 100 may control the external display device connected to the electronic apparatus 100 based on the user voice signal received through the microphone 180. The electronic apparatus 100 may generate a control signal for controlling the external display device so that the operation corresponding to the user voice signal is performed on the external display device, and transmit the generated control signal to the external display device. The electronic apparatus 100 may store a remote control application for controlling the external display device. The electronic apparatus 100 may transmit the generated control signal to the external display device using at least one communication method among Bluetooth, Wi-Fi, and infrared rays. For example, when the user voice signal for displaying the content A is received, the electronic apparatus 100 may transmit a control signal to the external display device to control the content A to be displayed on the external display device. The electronic apparatus 100 may refer to various terminal devices capable of installing remote control applications such as a smart phone and an AI speaker.

According to various embodiments, the electronic apparatus 100 may use the remote control device to control the external display device connected to the electronic apparatus 100 based on the user voice signal received through the microphone 180. The electronic apparatus 100 may transmit, to the remote control device, the control signal for controlling the external display device so that the operation corresponding to the user voice signal is performed on the external display device. The remote control device may transmit the control signal received from the electronic apparatus 100 to the external display device. For example, when the user voice signal for displaying the content A is received, the electronic apparatus 100 may transmit the control signal to the remote control device to control the content A to be displayed on the external display device, and the remote control device transmit the received control signal to the external display device.

The electronic apparatus 100 may receive the user voice signal in various ways.

According to various embodiments, the electronic apparatus 100 may receive the user voice signal through the microphone 180 included in the electronic apparatus 100.

According to various embodiments, the electronic apparatus 100 may receive the user voice signal from the external device including the microphone. The external device may refer to the remote control device, the smartphone, etc. The received user voice signal may be a digital voice signal, but may also be an analog voice signal depending on the implementation. The electronic apparatus 100 may receive the user voice signal through a wireless communication method such as Bluetooth or Wi-Fi.

The electronic apparatus 100 may convert the user voice signal in various ways.

According to various embodiments, the electronic apparatus 100 may acquire text information corresponding to the user voice signal from the external server. The electronic apparatus 100 may transmit the user voice signal (audio signal or digital signal) to the external server. The external server may refer to a voice recognition server. The voice recognition server may convert the user voice signal into text information using speech to text (STT). Furthermore, the external server may transmit the text information corresponding to the converted user voice signal to the electronic apparatus 100.

According to various embodiments, the electronic apparatus 100 itself may acquire the text information corresponding to the user voice signal. The electronic apparatus 100 may also directly apply the speech to text (STT) function to a digital voice signal, convert the digital voice signal into the text information, and transmit the converted text information to the external server.

The external server may transmit information to the electronic apparatus 100 in various ways.

According to various embodiments, the external server may transmit the text information corresponding to the user voice signal to the electronic apparatus 100. The external server may be a server that performs a voice recognition function which converts the user voice signal into the text information.

According to various embodiments, the external server may transmit at least one of the text information corresponding to the user voice signal or search result information corresponding to the text information to the electronic apparatus 100. In addition to the voice recognition function, which converts the user voice signal into the text information, the external server may also perform a search result provision function which provides search result information corresponding to the text information. For example, the external server may be a server that performs both the voice recognition function and the search result provision function. In another example, the external server may only perform the voice recognition function, and the search result provision function may be performed by a separate server. The external server may transmit the text information to a separate server to acquire search results, and then acquire the search results corresponding to the text information from the separate server.

The electronic apparatus 100 may communicate with the external device and the external server in various ways.

According to various embodiments, communication modules for communication with external devices and external servers may be implemented identically. For example, the electronic apparatus 100 may communicate with the external devices using a Bluetooth module, and may also communicate with the external servers using the Bluetooth module.

According to various embodiments, communication modules for communication with external devices and external servers may be implemented separately. For example, the electronic apparatus 100 may communicate with the external device using a Bluetooth module, and with the external server using an Ethernet modem or Wi-Fi module.

FIG. 5 is a diagram for describing a process of processing an image in the electronic apparatus 100 according to an embodiment.

Referring to FIG. 5, the electronic apparatus 100 may include the substrate 10. The substrate 10 may be a plate on which various hardware modules are disposed.

The substrate 10 may include at least one of the input connector 11, the output connector 12, the first capacitor 21, the second capacitor 22, the conversion module 30, the transmission module 40, the timing module 50, and an image processor 60.

The electronic apparatus 100 may receive the input image through the input connector 11. The electronic apparatus 100 may receive the input image and transmit the received input image to the first capacitor 21.

The input connector 11 may be a connector that receives data (e.g., an image) from an external device. The input connector 11 may be an input connector of a serial digital interface (SDI).

The electronic apparatus 100 may transmit the input image to the first capacitor 21 using first impedance 1.

The first capacitor 21 may be a decoupling capacitor. The first capacitor 21 may be a noise filter connected to the input connector 11 to remove noise.

After the input image passes through the first capacitor 21, the electronic apparatus 100 may transmit the input image to the conversion module 30 using second impedance 2.

The electronic apparatus 100 may convert (or change or process) the input image into the first converted image using the conversion module 30.

The conversion module 30 may be the equalization (EQ) module. The conversion module 30 may convert the feature information of the image. The conversion module 30 may convert an image based on the setting information of the display device to which the image is output. The image output by the conversion module 30 may be described as the converted image. The setting information may include at least one of the size information, the resolution information, and the color information of the display or display device.

The electronic apparatus 100 may transmit the first converted image acquired from the conversion module 30 to the transmission module 40. The electronic apparatus 100 may transmit the first converted image to the transmission module 40 using a third impedance 3.

The transmission module 40 may include the bridge integrated circuit (BIC). The transmission module 40 may perform an operation of transmitting the first converted image to the display or display device.

The electronic apparatus 100 may transmit the first converted image from the transmission module 40 to the image processor 60. The transmission module 40 may transmit the first converted image to the image processor 60 using seventh impedance 7.

The image processor 60 may control the display or display device to output the first converted image.

The image processor 60 may be included in at least one processor 120 included in the electronic apparatus 100.

According to an embodiment, the image processor 60 may be included in the image processing device. The image processing device may include the substrate 10. The image processor 60 may be disposed on the substrate 10 included in the image processing device.

According to an embodiment, the image processor 60 may be included in the display device. The image processor 60 may not be included in the substrate 10 included in the image processing device. The image processor 60 may be disposed on the display device.

The image processing device may be described as the image processing module, and the display device may be described as the display module.

The electronic apparatus 100 may transmit the first converted image from the conversion module 30 to the timing module 50. The electronic apparatus 100 may transmit the first converted image from the conversion module 30 to the timing module 50 using fourth impedance 4.

The timing module 50 may be a module that performs a compensation operation for time delay. The electronic apparatus 100 may include a plurality of displays or a plurality of display devices. Synchronization is necessary to output images to a plurality of displays. However, since the image transmission process takes time, the synchronization problem may occur. The compensation operation for time delay may be performed to synchronize images output from the plurality of displays (or display devices). The timing module 50 may acquire first compensation information. The compensation information may be described as time compensation information, delay information for time compensation, timing information, sync information, etc.

The electronic apparatus 100 may transmit the first converted image and the first compensation information from the timing module 50 to the second capacitor 22. The electronic apparatus 100 may transmit the first converted image and the first compensation information from the timing module 50 to the second capacitor 22 using a fifth impedance 5.

The second capacitor 22 may be the decoupling capacitor. The second capacitor 22 may be the noise filter connected to the output connector 12 to remove noise.

After the first converted image and the first compensation information pass through the second capacitor 22, the electronic apparatus 100 may transmit the first converted image and the first compensation information to the output connector 12 using sixth impedance 6.

The electronic apparatus 100 may transmit the first converted image and the first compensation information to the external device or external module through the output connector 12.

The output connector 12 may be a connector that transmits (or outputs) data (e.g., image) to the external device. The output connector 12 may be an output connector of the SDI.

The SDI is a technology for transmitting uncompressed digital video signals over a single cable. The SDI serializes 10-bit word uncompressed digital video signals and transmits the signals over the cable (e.g., a 75Ω coaxial cable). The SDI may transmit image signals over long distances with relatively low transmission loss.

The input connector 11 or the output connector 12 may be referred to as an SDI connector or an SDI bayonet Neill-Concelman (SDI BNC) connector.

The electronic apparatus 100 may receive the input image through the input connector 11. The image signal may be transmitted to the conversion module 30 through the SDI single line. The image signal received by the conversion module 30 may be converted into a differential line signal. The converted image signal may be transmitted to the transmission module 40 and/or the timing module 50.

The image signal (or converted image) transmitted to the timing module 50 may be converted back into the SDI single line signal. The converted image signal may be transmitted to the output connector 12.

The transmission loss is likely to occur in a section where the image signal travels from the input connector 11 to the conversion module 30 and a section where the image signal travels from the timing module 50 to the output connector 12. The high-resolution image service may be achieved only when the transmission loss is low.

The dip-type SDI BNC connector may have difficulty maintaining stable impedance due to factors such as the pins of the connector, a solder joint, etc. The pins included in the connector may be disposed to penetrate through the substrate. An SDI printed circuit board (SDI PCB) pattern and the conversion module 30 and/or the timing module 50 may be disposed on the lower surface of the substrate 10.

The image signal may be received through the input connector 11. The image signal may be transmitted to the conversion module 30 through the first capacitor 21. An impedance drop may occur as the image signal passes through the first capacitor 21. Therefore, there is a need to compensate for (or correct) the impedance. The substrate 10 may be designed so that the second impedance 2 is greater than the first impedance 1. A magnitude (or value) of the second impedance 2 may be greater than that of the first impedance 1.

The impedance compensation may also be required during the image signal output process. A magnitude (or value) of the sixth impedance 6 may be greater than that of the fifth impedance 5.

The magnitudes of the first impedance 1 and the sixth impedance 6 may be a first value (or a first range).

The magnitudes of the first impedance 1 and the fifth impedance 5 may be a second value (or a second range).

The magnitudes of the third impedance 3, the fourth impedance 4, and the sixth impedance 4 may be a third value (or a third range).

The second value (or the average value of the second range) may be greater than the first value (the average value of the first range). The third value (or the average value of the third range) may be greater than the second value (the average value of the second range).

FIG. 6 is a diagram for describing a process of processing an image in the electronic apparatus 100 according to an embodiment.

An embodiment 600 of FIG. 6 illustrates a situation in which the substrate 10 is viewed from a first side. The detailed structure of the substrate 10 related thereto is described with reference to embodiments 610 and 620.

Embodiments 610 and 620 of FIG. 6 illustrate a structure in which the first capacitor 21, the second capacitor 22, the conversion module 30, and the transmission module 40 are disposed on the upper surface of the substrate 10.

In the embodiment 610, at least one of the input connector 11, the first capacitor 21, the conversion module 30, and the transmission module 40 may be disposed on the upper surface of the substrate 10. The input connector 11 may include the connector pin 11-1. The connector pin 11-1 may be disposed from the upper surface to the lower surface of the substrate 10. In the embodiment 610, the impedance discontinuity section (stub section) may occur depending on the arrangement of the connector pin 11-1.

In the embodiment 620, at least one of the output connector 12, the second capacitor 22, the timing module 50, and the transmission module 40 may be disposed on the upper surface of the substrate 10. The output connector 12 may include the connector pin 12-1. The connector pin 12-1 may be disposed from the upper surface to the lower surface of the substrate 10. In the embodiment 620, the impedance discontinuity section (stub section) may occur depending on the arrangement of the connector pin 12-1.

FIG. 7 is a diagram for describing a substrate having some modules for image processing disposed at the bottom according to an embodiment.

An embodiment 700 of FIG. 7 illustrates a situation in which the substrate 10 is viewed from a first side. The detailed structure of the substrate 10 related thereto is described with reference to embodiments 710 and 720.

In the embodiment 710, at least one of the input connector 11, the first capacitor 21, and the conversion module 30 may be disposed on the lower surface of the substrate 10. The transmission module 40 may be disposed on the upper surface of the substrate 10. The input connector 11 may include the connector pin 11-1. The connector pin 11-1 may be disposed from the upper surface to the lower surface of the substrate 10. In the embodiment 710, the connector pin 11-1 may be connected to the impedance disposed on the lower surface of the substrate 10. In the embodiment 710, the impedance discontinuity section (stub section) may not occur.

In the embodiment 720, at least one of the output connector 12, the second capacitor 22, and the timing module 50 may be disposed on the upper surface of the substrate 10. The transmission module 40 may be disposed on the upper surface of the substrate 10. The output connector 12 may include the connector pin 12-1. The connector pin 12-1 may be disposed from the upper surface to the lower surface of the substrate 10. In the embodiment 720, the connector pin 12-1 may be connected to the impedance disposed on the lower surface of the substrate 10. In the embodiment 720, the impedance discontinuity section (stub section) may not occur.

FIG. 8 is a diagram for describing a substrate having some modules for image processing disposed at the bottom according to an embodiment.

An embodiment 800 of FIG. 8 illustrates a situation in which the substrate 10 is viewed from a first side. The detailed structure of the substrate 10 related thereto is described with reference to embodiments 810 and 820.

In the embodiment 810, at least one of the input connector 11, the first capacitor 21, the conversion module 30, and the transmission module 40 may be disposed on the lower surface of the substrate 10. The input connector 11 may include the connector pin 11-1. The connector pin 11-1 may be disposed from the upper surface to the lower surface of the substrate 10. In the embodiment 810, the connector pin 11-1 may be connected to the impedance disposed on the lower surface of the substrate 10. In the embodiment 810, the impedance discontinuity section (stub section) may not occur.

In the embodiment 820, at least one of the output connector 12, the second capacitor 22, the timing module 50, and the transmission module 40 may be disposed on the upper surface of the substrate 10. The output connector 12 may include the connector pin 12-1. The connector pin 12-1 may be disposed from the upper surface to the lower surface of the substrate 10. In the embodiment 820, the connector pin 12-1 may be connected to the impedance disposed on the lower surface of the substrate 10. In the embodiment 820, the impedance discontinuity section (stub section) may not occur.

According to an embodiment, the substrate 10 may be implemented in which the embodiment 710 of FIG. 7 and the embodiment 820 of FIG. 8 are combined.

According to an embodiment, the substrate 10 may be implemented in which the embodiment 720 of FIG. 7 and the embodiment 810 of FIG. 8 are combined.

According to an embodiment, the substrate 10 may be implemented in which the embodiment 610 of FIG. 6 and the embodiment 720 of FIG. 7 are combined.

According to an embodiment, the substrate 10 may be implemented in which the embodiment 610 of FIG. 6 and the embodiment 820 of FIG. 8 are combined.

According to an embodiment, the substrate 10 may be implemented in which the embodiment 620 of FIG. 6 and the embodiment 710 of FIG. 7 are combined.

According to an embodiment, the substrate 10 may be implemented in which the embodiment 620 of FIG. 6 and the embodiment 780 of FIG. 8 are combined.

FIG. 9 is a diagram for describing some impedance connected to a connector according to an embodiment.

An embodiment 900 of FIG. 9 illustrates a situation in which the substrate 10 is viewed from a second side. An embodiment 900 of FIG. 9 illustrates a situation in which the input connector 11 or the output connector 12 is viewed from the transmission module 40. The detailed structure of the substrate 10 related thereto is described with reference to embodiments 910, 920, 930, and 940.

The substrate 10 may include a first layer L1, a second layer L2, a third layer L3, and a fourth layer L4. The first layer L1 may be described as a top layer. The fourth layer L4 may be described as a bottom layer.

The first layer L1 may include an insulator region and a conductor region. The first layer L1 may include a first sub-layer and a second sub-layer. The entire first sub-layer region may be the conductor region. The entire second sub-layer region may be the insulator region.

The second layer L2 may include the insulator region and the conductor region. The second layer L2 may include the first sub-layer and the second sub-layer. The entire first sub-layer region may be the conductor region. The entire second sub-layer region may be the insulator region.

The third layer L3 may include the insulator region and the conductor region. The third layer L3 may include the first sub-layer and the second sub-layer. A portion of the entire first sub-layer region may be the conductor region and the remainder may be the insulator region. The entire second sub-layer region may be the insulator region.

The fourth layer L4 may include the conductor region.

An impedance of the fourth layer L4 may vary depending on the arrangement structure of the conductor region. The impedance may vary depending on a width (or length) of the conductor region.

The connector pin 11-1 of the input connector 11 may be connected from the first layer L1 of the substrate 10 to the fourth layer L4.

The connector pin 12-1 of the output connector 12 may be connected from the first layer L1 of the substrate 10 to the fourth layer L4.

When viewed from the transmission module 40 toward the input connector 11 or the output connector 12, the fourth layer L4 may be divided into five regions H1, H2, H3, H4, and H5 from the leftmost to the rightmost.

The first region H1, the third region H3, and the fifth region H5 may be the conductor regions.

The second region H2 and the fourth region H4 may be insulator regions.

The length of the first region H1 and the length of the fifth region H5 may be the same.

The length of the second region H2 and the length of the fourth region H4 may be the same.

The length of the second region H2 may be greater than that of the first region H1.

The length of the fourth region H4 may be greater than that of the fifth region H5.

Depending on various embodiments, the length of the third region H3 may vary. As the length of the third region H3 decreases, the magnitude of the impedance may increase. As the length of the third region H3 decreases, the length of the second region H2 and/or the fourth region H4 may increase.

The embodiment 910 may represent the first impedance 1 of the embodiment 710 of FIG. 7 or the first impedance 1 of the embodiment 810 of FIG. 8.

The embodiment 920 may represent the first impedance 2 of the embodiment 710 of FIG. 7 or the second impedance 2 of the embodiment 810 of FIG. 8.

The length of the first region H1 corresponding to the first impedance 1 may be equal to that of the first region H1 corresponding to the second impedance 2.

The length of the second region H2 corresponding to the first impedance 1 may be smaller than that of the second region H2 corresponding to the second impedance 2.

The length of the third region H3 corresponding to the first impedance 1 may be longer than that of the third region H3 corresponding to the second impedance 2.

The length of the fourth region H4 corresponding to the first impedance 1 may be smaller than that of the fourth region H4 corresponding to the second impedance 2.

The length of the fifth region H5 corresponding to the first impedance 1 may be equal to that of the fifth region H5 corresponding to the second impedance 2.

The magnitude of the first impedance 1 may be smaller than that of the second impedance 2.

The connector pin 11-1 of the input connector 11 may be in contact with a conductor corresponding to the third region H3.

The embodiment 930 may represent the fifth impedance 5 of the embodiment 720 of FIG. 7 or the fifth impedance 5 of the embodiment 820 of FIG. 8.

The embodiment 940 may represent the sixth impedance 6 of the embodiment 720 of FIG. 7 or the sixth impedance 6 of the embodiment 820 of FIG. 8.

The length of the first region H1 corresponding to the sixth impedance 6 may be equal to that of the first region H1 corresponding to the fifth impedance 5.

The length of the second region H2 corresponding to the sixth impedance 6 may be smaller than that of the second region H2 corresponding to the fifth impedance 5.

The length of the third region H3 corresponding to the sixth impedance 6 may be longer than that of the third region H3 corresponding to the fifth impedance 5.

The length of the fourth region H4 corresponding to the sixth impedance 6 may be smaller than that of the fourth region H4 corresponding to the fifth impedance 5.

The length of the fifth region H5 corresponding to the sixth impedance 6 may be equal to that of the fifth region H5 corresponding to the fifth impedance 5.

The magnitude of the sixth impedance 6 may be smaller than that of the fifth impedance 5.

The connector pin 12-1 of the output connector 12 may be in contact with the conductor corresponding to the third region H3.

According to an embodiment, the second layer L2 and the third layer L3 may be omitted.

According to an embodiment, the fourth layer L4 may include the insulator region and the conductor region.

According to an embodiment, the substrate 10 may be implemented as a single layer.

FIG. 10 is a diagram illustrating some impedance connected to a connector, according to an embodiment.

An embodiment 1000 of FIG. 10 illustrates a situation in which the substrate 10 is viewed from a second side. An embodiment 1000 of FIG. 10 illustrates a situation in which the input connector 11 or the output connector 12 is viewed from the transmission module 40. The detailed structure of the substrate 10 related thereto is described with reference to embodiments 1010, 1020, 1030, and 1040.

The substrate 10 may include a first layer L1, a second layer L2, a third layer L3, and a fourth layer L4. A detailed description related thereto is described with reference to FIG. 9. Duplicate descriptions will be omitted.

When viewed from the transmission module 40 toward the input connector 11 or the output connector 12, the fourth layer L4 may be divided into five regions H1, H2, H3, H4, and H5 from the leftmost to the rightmost. A detailed description related thereto is described with reference to FIG. 9. Duplicate descriptions will be omitted.

According to various embodiments, the lengths of the first region H1 and/or the fifth region H5 may vary. As the length of the first region H1 and/or the fifth region H5 increases, the magnitude of impedance may be large. As the length of the first region H1 and/or the fifth region H5 increases, the length of the second region H2 and/or the fourth region H4 may decrease.

The embodiment 1010 may represent the first impedance 1 of the embodiment 710 of FIG. 7 or the first impedance 1 of the embodiment 810 of FIG. 8.

The embodiment 1020 may represent the second impedance 2 of the embodiment 710 of FIG. 7 or the second impedance 2 of the embodiment 810 of FIG. 8.

The length of the first region H1 corresponding to the first impedance 1 may be smaller than that of the first region H1 corresponding to the second impedance 2.

The length of the second region H2 corresponding to the first impedance 1 may be greater than that of the second region H2 corresponding to the second impedance 2.

The length of the third region H3 corresponding to the first impedance 1 may be equal to that of the third region H3 corresponding to the second impedance 2.

The length of the fourth region H4 corresponding to the first impedance 1 may be greater than that of the fourth region H4 corresponding to the second impedance 2.

The length of the fifth region H5 corresponding to the first impedance 1 may be smaller than that of the fifth region H5 corresponding to the second impedance 2.

The magnitude of the first impedance 1 may be smaller than that of the second impedance 2.

The connector pin 11-1 of the input connector 11 may be in contact with a conductor corresponding to the third region H3.

The embodiment 1030 may represent the fifth impedance 5 of the embodiment 720 of FIG. 7 or the fifth impedance 5 of the embodiment 820 of FIG. 8.

The embodiment 1040 may represent the sixth impedance 6 of the embodiment 720 of FIG. 7 or the sixth impedance 6 of the embodiment 820 of FIG. 8.

The length of the first region H1 corresponding to the sixth impedance 6 may be smaller than that of the first region H1 corresponding to the fifth impedance 5.

The length of the second region H2 corresponding to the first impedance 6 may be longer than that of the second region H2 corresponding to the second impedance 5.

The length of the third region H3 corresponding to the sixth impedance 6 may be equal to that of the third region H3 corresponding to the fifth impedance 5.

The length of the fourth region H4 corresponding to the sixth impedance 6 may be greater than that of the fourth region H4 corresponding to the fifth impedance 5.

The length of the fifth region H5 corresponding to the sixth impedance 6 may be smaller than that of the fifth region H5 corresponding to the fifth impedance 5.

The magnitude of the sixth impedance 6 may be smaller than that of the fifth impedance 5.

The connector pin 12-1 of the output connector 12 may be in contact with the conductor corresponding to the third region H3.

FIG. 11 is a diagram for describing impedance on a substrate where some modules for image processing are disposed at a top according to an embodiment.

An embodiment 1100 of FIG. 11 is a diagram illustrating impedance according to the arrangement structure of the substrate 10 in the embodiment 610 of FIG. 6.

Table 1110 shows impedance according to a position from the transmission module 40 to the input connector 11. There may be a normal impedance range. The normal impedance range may be described as a preset impedance range. An upper limit of the normal impedance range may be Zu, and a lower limit of the normal impedance range may be zl.

The impedance may increase at a position r1 where the first capacitor 21 is disposed.

The impedance may decrease at a position r2 where the connect pin 11-1 of the input connector 11 is disposed. The impedance of the substrate 10 at the position r2 may fall outside the normal impedance range. The position r2 may be included in an impedance mismatch section (stub section) due to the connect pin 11-1.

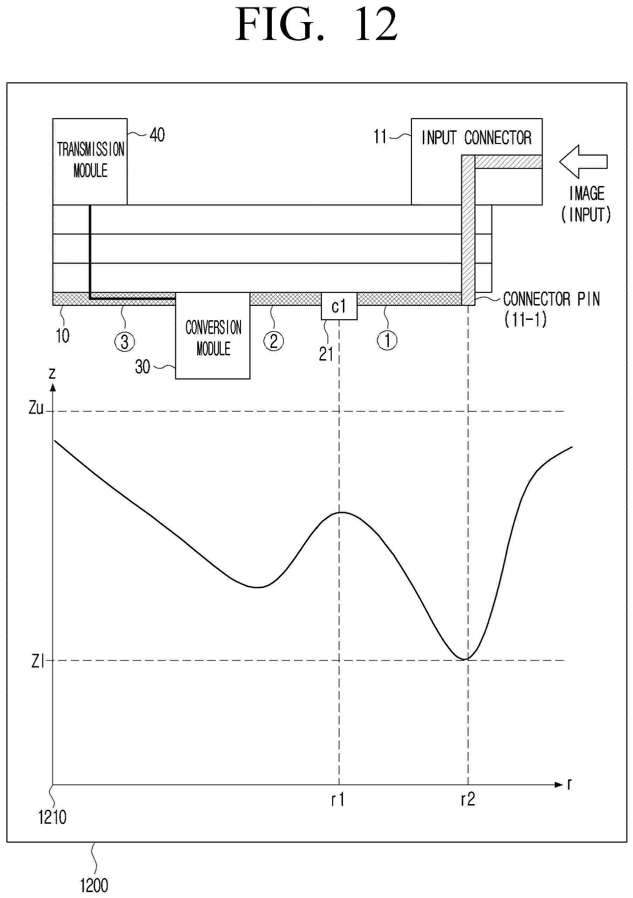

FIG. 12 is a diagram for describing impedance on a substrate where some modules for image processing are disposed at a bottom according to an embodiment.

An embodiment 1200 of FIG. 12 is a diagram illustrating impedance according to the arrangement structure of the substrate 10 in the embodiment 710 of FIG. 7.

Table 1210 shows impedance according to the position from the transmission module 40 to the input connector 11. There may be a normal impedance range. The normal impedance range may be described as a preset impedance range. An upper limit of the normal impedance range may be Zu, and a lower limit of the normal impedance range may be zl.

The impedance may increase at a position r1 where the first capacitor 21 is disposed.

The impedance may decrease at a position r2 where the connect pin 11-1 of the input connector 11 is disposed. The impedance of the substrate 10 at the position r2 may not fall outside the normal impedance range. The impedance of the substrate 10 at the position r2 may fall within the normal impedance range. Unlike the embodiment 1100 of FIG. 11, in the embodiment 1200 of FIG. 12, the impedance corresponding to the substrate 10 may fall within the normal impedance range throughout the entire section.

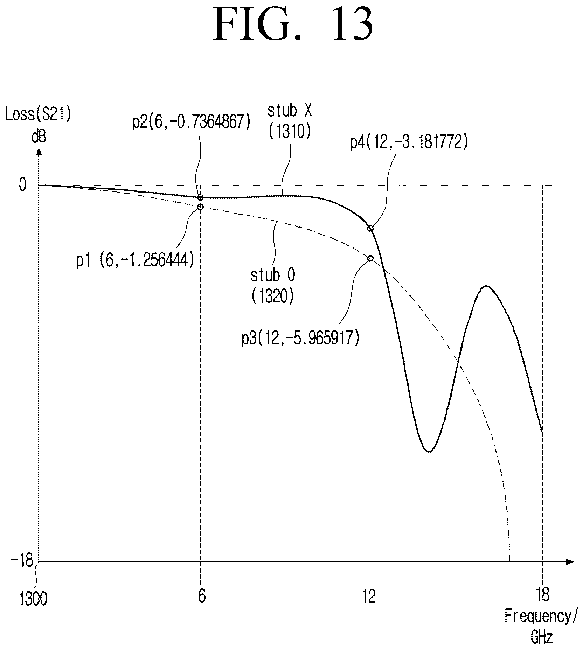

FIG. 13 is a diagram for describing loss values according to frequency depending on module arrangement according to various embodiments.

Table 1300 of FIG. 13 may represent a transmission loss level depending on the structure of the substrate 10. An x-axis of the table 1300 represents frequency, and the unit may be GHz. A y-axis of table 1300 represents the transmission loss value, and the unit may be dB. dB may represent a power ratio. As the loss value increases, the loss level may decrease, and as the loss value decreases, the loss level may increase. As an absolute value of the loss value increases, the loss level may increase.

An embodiment 1310 may correspond to the embodiments 610 and 620 of FIG. 6. The embodiment 1310 may represent the electronic apparatus 100 in which both the conversion module 30 and the transmission module 40 are disposed on the upper surface of the substrate 10.

An embodiment 1320 may correspond to the embodiments 710 and 720 of FIG. 7 or the embodiments 810 and 820 of FIG. 8. The embodiment 1310 may represent the electronic apparatus 100 in which at least one of the conversion module 30 and the transmission module 40 is disposed on the lower surface of the substrate 10.

For example, the frequency used to transmit the image signal may be 6 GHz or 12 GHz.

When the frequency used to transmit the image signal is 6 GHz, the loss value corresponding to the embodiment 1310 may be '-1.256444', and the loss value corresponding to embodiment 1320 may be '-0.7364867'. The transmission loss level of the embodiment 1320 may be less than that of the embodiment 1310. The embodiment 1320 may have better transmission efficiency than the embodiment 1310.

When the frequency used to transmit the image signal is 12GHz, the loss value corresponding to the embodiment 1310 may be '5.965917', and the loss value corresponding to embodiment 1320 may be '-3.181772'. The transmission loss level of the embodiment 1320 may be less than that of the embodiment 1310. The embodiment 1320 may have better transmission efficiency than the embodiment 1310.

Scattering parameters (S parameters) may be used to acquire the loss value. The S parameters may be represented in matrix form, and S21 may be calculated as a voltage ratio. The loss value acquired through S21 may have a negative value.

FIG. 14 is a diagram for describing capacitor arrangement according to various embodiments.

Embodiments 1410, 1420, and 1430 of FIG. 14 illustrate the substrate 10 in which the arrangement of the first capacitor 21 is changed from the embodiment 710 of FIG. 7.

From the direction looking from the conversion module 30 toward the timing module 50, the fourth layer L4 may be divided into three regions W1, W2, and W3 from the leftmost to the rightmost.

From the direction looking from the first capacitor 21 toward the second capacitor 22, the fourth layer L4 may be divided into three regions W1, W2, and W3 from the leftmost to the rightmost.

The sixth region W1 of the fourth layer L4 may represent a region from a position corresponding to the transmission module 40 to a position corresponding to the conversion module 30. The sixth region W1 may correspond to the third impedance 3 and/or the fourth impedance 4.

The seventh region W2 of the fourth layer L4 may represent a region from the position corresponding to the conversion module 30 to the position corresponding to the first capacitor 21. The seventh region W2 may correspond to the second impedance 2 and/or the fifth impedance 5.

The eighth region W3 of the fourth layer L4 may represent a region from a position corresponding to the first capacitor 21 to a position corresponding to the connector pin 11-1 of the input connector 11. The eighth region W3 may correspond to the first impedance 1 and/or the sixth impedance 6.

In an embodiment 1410, the first capacitor 21 may be disposed so that the length of the seventh region W2 is smaller than that of the eighth region W3.

In an embodiment 1420, the first capacitor 21 may be disposed so that the length of the seventh region W2 is equal to that of the eighth region W3.

In an embodiment 1430, the first capacitor 21 may be disposed so that the length of the seventh region W2 is greater than that of the eighth region W3.

In the description of FIG. 14, the conversion module 30 may be replaced with the timing module 50, the first capacitor 21 may be replaced with the second capacitor 22, the input connector 11 may be replaced with the output connector 12, and the connector pin 11-1 may be replaced with the connector pin 12-1.

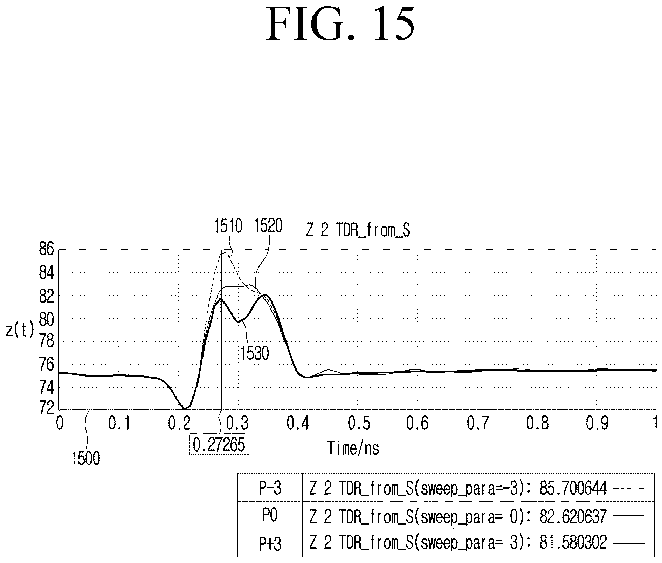

FIG. 15 is a diagram for describing a change in impedance depending on module arrangement according to various embodiments.

Table 1500 of FIG. 15 illustrates changes in impedance over time with reference to the embodiments 1410, 1420, and 1430 of FIG. 14.

An embodiment 1510 of FIG. 15 may correspond to the embodiment 1410 of FIG. 14.

An embodiment 1520 of FIG. 15 may correspond to the embodiment 1420 of FIG. 14.

An embodiment 1530 of FIG. 15 may correspond to the embodiment 1430 of FIG. 14.

In an embodiment 1510 of FIG. 15, the change in impedance over time may be relatively large.

In the embodiment 1520 of FIG. 15, the change in impedance over time may be relatively small.

In the embodiment 1530 of FIG. 15, the change in impedance over time may be relatively large.

The embodiment 1520 in which the change in impedance is relatively small may be said to have higher impedance stability than the remaining embodiments 1510 and 1530. The arrangement structure of the first capacitor 21 of the embodiment 1420 of FIG. 14, which corresponds to the embodiment 1520, may have relatively high impedance stability. As in the embodiment 1420 of FIG. 14, the electronic apparatus 100 may have the first capacitor 21 disposed such that the length of the seventh region W2 is equal to that of the eighth region W3.

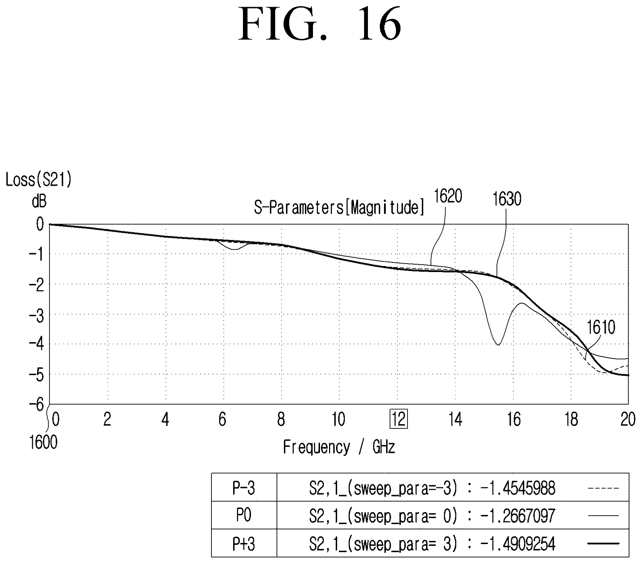

FIG. 16 is a diagram for describing loss values according to frequency depending on module arrangement according to various embodiments.

Table 1600 of FIG. 16 shows the transmission loss level according to frequency with reference to the embodiments 1410, 1420, and 1430 of FIG. 14. As the transmission loss value (loss, S21) increases (as the absolute value decreases), the transmission loss level may decrease. As the transmission loss value decreases (as the absolute value increases), the transmission loss level may increase.

An embodiment 1610 of FIG. 16 may correspond to the embodiment 1410 of FIG. 14.

An embodiment 1620 of FIG. 16 may correspond to the embodiment 1420 of FIG. 14.

An embodiment 1630 of FIG. 16 may correspond to the embodiment 1430 of FIG. 14.

In the embodiment 1610 of FIG. 16, the transmission loss level according to frequency may be relatively large.

In the embodiment 1620 of FIG. 16, the transmission loss level according to frequency may be relatively small.

In the embodiment 1630 of FIG. 16, the transmission loss level according to frequency may be relatively large.

The embodiment 1620 in which the change in impedance is relatively small may be said to have the lower transmission loss level than the remaining embodiments 1610 and 1630. The arrangement structure of the first capacitor 21 of the embodiment 1420 of FIG. 14, which corresponds to the embodiment 1620 of FIG. 14, may have the relatively low transmission loss level. As in the embodiment 1420 of FIG. 14, the electronic apparatus 100 may have the first capacitor 21 disposed such that the length of the seventh region W2 is equal to that of the eighth region W3.

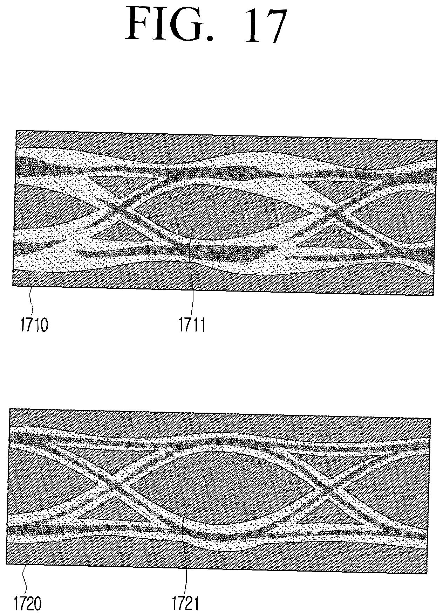

FIG. 17 is a diagram for describing an eye diagram according to a module arrangement according to various embodiments.

An eye diagram 1710 of FIG. 17 represents an eye diagram according to the embodiments 610 and 620 of FIG. 6.

The eye diagram 1720 of FIG. 17 illustrates an eye diagram according to the embodiments 710 and 720 of FIG. 7 or the embodiments 810 and 820 of FIG. 8.

The eye diagram may be a tool for representing signal quality and stability in a time domain in a digital communication system.

The x-axis of the eye diagram may represent a time, and the y-axis may represent a voltage.

In the eye diagram 1710, a waveform intrudes into a regular hexagon. In the eye diagram 1720, the waveform does not intrude into the regular hexagon. It may be determined that the waveform of the eye diagram 1720 has little noise and is stable.

A thickness of the waveform of the eye diagram 1710 is greater than that of the eye diagram 1720. It may be determined that the waveform of the eye diagram 1720 has little noise and is stable.

A width of the region 1711 representing the eye of the eye diagram 1710 is smaller than that of the region 1721 representing the eye of the eye diagram 1720. It may be determined that the waveform of the eye diagram 1720 has little noise and is stable.

Therefore, the embodiments 710 and 720 of FIG. 7 or the embodiments 810 and 820 of FIG. 8, which correspond to the eye diagram 1720, may be more efficient in terms of the signal transmission than the embodiments 610 and 620 of FIG. 6, which correspond to the eye diagram 1710.

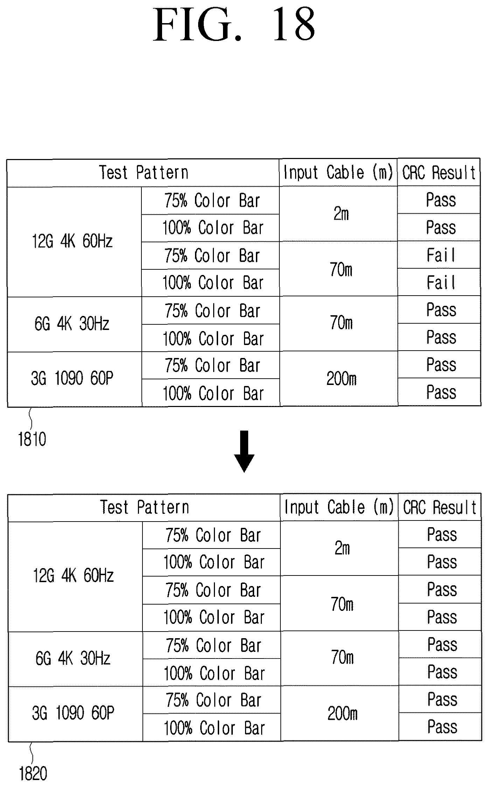

FIG. 18 is a diagram for describing test results according to a type of images and a length of cables according to various embodiments.

Table 1810 of FIG. 18 shows cyclic redundancy check (CRC) results according to the embodiments 610 and 620 of FIG. 6.

The CRC check may be a tool for determining whether an error has occurred during the data transmission.

Table 1820 of FIG. 18 shows the cyclic redundancy check (CRC) results according to the embodiments 710 and 720 of FIG. 7 or the embodiments 810 and 820 of FIG. 8.

Referring to table 1810, the CRC result for a 12-gigabyte 4K image signal failed when the input cable was 70 m.

Referring to table 1820, the CRC result for a 12-gigabyte 4K image signal succeeded when the input cable was 70 m.

The embodiments 710 and 720 of FIG. 7 or the embodiments 810 and 820 of FIG. 8, which correspond to the table 1820, may be more stable in terms of the signal transmission than the embodiments 610 and 620 of FIG. 6, which correspond to the table 1810.

FIG. 19 is a drawing for describing a layout structure of a substrate according to an embodiment.

FIG. 19 illustrates the substrate 10 according to the embodiments 710 and 720 of FIG. 7 or the embodiments 810 and 820 of FIG. 8.

An embodiment 1910 of FIG. 19 may represent an upper surface 10-1 of the substrate 10. The input connector 11 may be disposed on the upper surface 10-1 of the substrate 10. The output connector 12 may be disposed on the upper surface 10-1 of the substrate 10.

An embodiment 1920 of FIG. 19 may represent a lower surface 10-2 of the substrate 10.

The first capacitor 21 and the conversion module 30 may be disposed on the lower surface 10-2 of the substrate 10. The connector pin 11-1 of the input connector 11 may be exposed on the lower surface 10-2.

According to an embodiment, a first discharge element 71 may be disposed on the lower surface 10-2 of the substrate 10. The first discharge element 71 may be a semiconductor element that discharges static electricity. The first discharge element 71 may be described as a first electrostatic discharge (ESD) diode, a first discharge diode, or the like. The first discharge element 71 may be disposed within a preset distance from the first capacitor 21. The first discharge element 71 may be connected to the first impedance 1. The first discharge element 71 may be disposed in the eighth region W3 of FIG. 14.

The second capacitor 22 and the timing module 50 may be disposed on the lower surface 10-2 of the substrate 10. The connector pin 12-1 of the output connector 12 may be exposed on the lower surface 10-2.

According to an embodiment, the second discharge element may be disposed on the lower surface 10-2 of the substrate 10. The second discharge element may be a semiconductor element that performs a function of discharging static electricity. The second discharge element may be described as a second electrostatic discharge) diode, a second discharge diode, etc. The second discharge element may be disposed within a preset distance from the second capacitor 22. The second discharge element may be connected to the sixth impedance 6. The second discharge element may be disposed in the eighth region W3 of FIG. 14.

When the capacitor component generated at the connector pin overlaps with the input capacitor component at the conversion module 30, the image quality may deteriorate. Additional decoupling capacitors 21 and 22 and the discharge element (e.g., the ESD diode) may be disposed between the conversion module 30 and the pin 11-1 of the input connector 11.

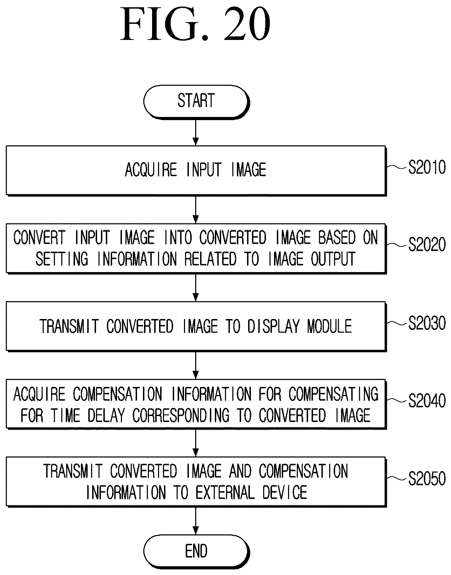

FIG. 20 is a flowchart for describing a controlling method of the electronic apparatus 100 according to an embodiment.

Referring to FIG. 20, a control method of the electronic apparatus 100 including the input/output interface 160 including the input connector 11 and the output connector disposed on the upper surface of the substrate 10, the conversion module 30 disposed on the lower surface of the substrate 10, the transmission module 40 connected to the substrate 10, and the timing module 50 disposed on the lower surface of the substrate 10 includes a step (S2010) of acquiring the input image through the input connector 11, a step (S2020) of converting, by the conversion module 30, the input image into the converted image based on the setting information related to image output, a step (S2030) of transmitting the converted image to the display module through the transmission module 40, a step (S2040) of acquiring the compensation information for compensating for the time delay corresponding to the converted image through the timing module 50, and a step (S2050) of transmitting the converted image and the compensation information to the external device through the output connector.

The setting information may include at least one of the size information of the display module on which the converted image will be displayed, the resolution information of the display module, or the color information of the display module.

The control method may further include a step of controlling the display module to display the converted image.

The pin of the input connector 11 and the pin of the output connector may be connected to the lower surface of the substrate 10 through the substrate 10.

The substrate 10 includes the first capacitor 21 disposed between the pin of the input connector 11 corresponding to the lower surface of the substrate 10 and the conversion module 30, and the second capacitor 22 disposed between the pin of the output connector corresponding to the lower surface of the substrate 10 and the timing module 50.

The control method may further include a step of filtering noise through the first capacitor 21 and the second capacitor 22.

The control method may further include a step of transmitting the input image to the conversion module 30 through the first impedance connecting the pin of the input connector 11 and the first capacitor 21 and the second impedance connecting the first capacitor 21 and the conversion module 30, and a step of transmitting the converted image to the transmission module 40 through the third impedance connecting the conversion module 30 and the transmission module 40.

The control method may further include a step of transmitting the converted image to the timing module 50 through the fourth impedance connecting the transmission module 40 and the timing module 50, and a step of transmitting the converted image and the compensation information to the output connector through the fifth impedance connecting the timing module 50 and the second capacitor 22 and the sixth impedance connecting the second capacitor 22 and the pin of the output connector.

The magnitude of the first impedance may be smaller than that of the second impedance, and the magnitude of the sixth impedance may be smaller than that of the fifth impedance.

The substrate 10 includes the first discharge element disposed between the pin of the input connector 11 corresponding to the lower surface of the substrate 10 and the first capacitor 21, and the second discharge element disposed between the pin of the output connector corresponding to the lower surface of the substrate 10 and the second capacitor 22, and the control method may further include a step of filtering the static electricity through the first discharge element and the second discharge element.

The input/output interface 160 may be the serial digital interface (SDI).

Meanwhile, the above-described methods according to various embodiments of the present disclosure may be implemented in a form of application that may be installed in the existing electronic apparatus.

In addition, the above-described methods according to various embodiments of the present disclosure may be implemented only by software upgrade or hardware upgrade of the existing electronic apparatus.

Further, various embodiments of the disclosure described above may also be performed by an embedded server included in the electronic apparatus or an external server of at least one of the electronic apparatus or the display device.

Meanwhile, according to an embodiment of the disclosure, various embodiments described above may be implemented by software including instructions stored in a machine-readable storage medium (for example, a computer-readable storage medium). A machine is a device capable of calling a stored instruction from a storage medium and operating according to the called instruction, and may include the electronic apparatus of the disclosed embodiments. In the case in which a command is executed by the processor, the processor may directly perform a function corresponding to the command or other components may perform the function corresponding to the command under a control of the processor. The command may include codes created or executed by a compiler or an interpreter. The machine-readable storage medium may be provided in a form of a non-transitory storage medium. Here, the term "non-transitory" means that the storage medium is tangible without including a signal, and does not distinguish whether data are semi-permanently or temporarily stored in the storage medium.

In addition, according to an embodiment of the disclosure, the above-described methods according to the diverse embodiments may be included and provided in a computer program product. The computer program product may be traded as a product between a seller and a purchaser. The computer program product may be distributed in a form of a storage medium (for example, a compact disc read only memory (CD-ROM)) that may be read by the machine or online through an application store (for example, PlayStore^{™}). In case of the online distribution, at least a portion of the computer program product may be at least temporarily stored in a storage medium such as a memory of a server of a manufacturer, a server of an application store, or a relay server or be temporarily generated.

In addition, each of components (for example, modules or programs) according to various embodiments described above may include a single entity or a plurality of entities, and some of the corresponding sub-components described above may be omitted or other sub-components may be further included in the diverse embodiments. Alternatively or additionally, some components (e.g., modules or programs) may be integrated into one entity and perform the same or similar functions performed by each corresponding component prior to integration. Operations performed by the modules, the programs, or the other components according to the diverse embodiments may be executed in a sequential manner, a parallel manner, an iterative manner, or a heuristic manner, at least some of the operations may be performed in a different order or be omitted, or other operations may be added.

Although embodiments of the disclosure have been illustrated and described hereinabove, the disclosure is not limited to the abovementioned specific embodiments, but may be variously modified by those skilled in the art to which the disclosure pertains without departing from the gist of the disclosure as disclosed in the accompanying claims. These modifications should also be understood to fall within the scope and spirit of the disclosure.

## Claims

1. An electronic apparatus, comprising:
a substrate;
an input/output interface including an input connector and an output connector disposed on an upper surface of the substrate;
a conversion module disposed on a lower surface of the substrate; and
at least one processor,
wherein the at least one processor is configured to acquire an input image through the input connector,
convert, by the conversion module, the input image into a converted image based on setting information related to image output, and
display the converted image through a display module.

2. The electronic apparatus as claimed in claim 1, further comprising:
a transmission module connected to the conversion module,
wherein the at least one processor is configured to transmit the converted image to the display module through the transmission module.

3. The electronic apparatus as claimed in claim 1, further comprising:
a timing module disposed on the lower surface of the substrate,
wherein the at least one processor is configured to acquire compensation information for compensating for a time delay corresponding to the converted image through the timing module, and
transmit the converted image and the compensation information to an external device through the output connector.

4. The electronic apparatus as claimed in claim 1, wherein the setting information includes at least one of size information of the display module that displays the converted image, resolution information of the display module, or color information of the display module.

5. The electronic apparatus as claimed in claim 3, wherein a pin of the input connector and a pin of the output connector are connected to the lower surface of the substrate through the substrate.

6. The electronic apparatus as claimed in claim 5, wherein the substrate includes:
a first capacitor disposed between the pin of the input connector corresponding to the lower surface of the substrate and the conversion module; and
a second capacitor disposed between a pin of the output connector corresponding to the lower surface of the substrate and the timing module, and
the at least one processor is configured to filter noise through the first capacitor and the second capacitor.

7. The electronic apparatus as claimed in claim 6, wherein the at least one processor is configured to transmit the input image to the conversion module through a first impedance connecting the pin of the input connector and the first capacitor, and a second impedance connecting the first capacitor and the conversion module, and
transmit the converted image to the transmission module through a third impedance connecting the conversion module and the transmission module.

8. The electronic apparatus as claimed in claim 7, wherein the at least one processor is configured to transmit the converted image to the timing module through a fourth impedance connecting the transmission module and the timing module, and
transmit the converted image and the compensation information to the output connector through a fifth impedance connecting the timing module and the second capacitor, and a sixth impedance connecting the second capacitor and the pin of the output connector.

9. The electronic apparatus as claimed in claim 8, wherein a magnitude of the first impedance is smaller than that of the second impedance, and
a magnitude of the sixth impedance is smaller than that of the fifth impedance.

10. The electronic apparatus as claimed in claim 6, wherein the substrate includes:
a first discharge element disposed between the pin of the input connector corresponding to the lower surface of the substrate and the first capacitor; and
a second discharge element disposed between the pin of the output connector corresponding to the lower surface of the substrate and the second capacitor, and
the at least one processor is configured to filter static electricity through the first discharge element and the second discharge element.

11. A control method of an electronic apparatus including an input/output interface including an input connector and an output connector disposed on an upper surface of a substrate, and a conversion module disposed on a lower surface of the substrate, the control method comprising:
acquiring an input image through the input connector;
converting, by the conversion module, the input image into a converted image based on setting information related to image output; and
displaying the converted image through a display module.

12. The control method as claimed in claim 11, wherein the electronic apparatus further includes a transmission module connected to the conversion module, and
the control method further includes transmitting the converted image to the display module through the transmission module.

13. The control method as claimed in claim 11, wherein the electronic apparatus further includes a timing module disposed on the lower surface of the substrate, and
the control method further includes:
acquiring compensation information for compensating for a time delay corresponding to the converted image through the timing module; and
transmitting the converted image and the compensation information to an external device through the output connector.

14. The control method as claimed in claim 11, wherein the setting information includes at least one of size information of the display module that displays the converted image, resolution information of the display module, or color information of the display module.

15. The control method as claimed in claim 13, wherein a pin of the input connector and a pin of the output connector are connected to the lower surface of the substrate through the substrate.
